# EUROPEAN PATENT APPLICATION

(11) **EP 4 432 367 A1**
(43) Date of publication of application: **18.09.2024**
(21) Application number: 21968677.1
(22) Date of filing: 24.12.2021
(51) Int. Cl.: H01L 29/51

(54) **CHIP AND TERMINAL**

(71) Applicant: Huawei Technologies Co., Ltd., Shenzhen, Guangdong 518129 (CN)
(72) Inventor: TAN, Wanliang, Shenzhen, Guangdong 518129 (CN); LI, Yuxing, Shenzhen, Guangdong 518129 (CN); CAI, Jialin, Shenzhen, Guangdong 518129 (CN); LV, Hangbing, Shenzhen, Guangdong 518129 (CN); XU, Jeffrey Junhao, Shenzhen, Guangdong 518129 (CN)
(74) Representative: Goddar, Heinz J.
(86) International application number: PCT/CN2021/141237
(87) International publication number: WO 2023/115547

(57) **Abstract**

Embodiments of this application relate to the field of chip technologies, and in particular, to a chip and a terminal, and provide a chip and a terminal, to adjust electrical symmetry and an on/off ratio of a first electrode, a ferroelectric function layer, and a second electrode. The chip includes the first electrode, a first ferroelectric function layer, a second ferroelectric function layer, and the second electrode that are sequentially stacked. The first ferroelectric function layer and the second ferroelectric function layer each include a ferroelectric oxide layer, the first ferroelectric function layer and/or the second ferroelectric function layer further include/includes a doping layer, electronegativity of the doping layer is different from electronegativity of the ferroelectric oxide layer, and a doping concentration of the doping layer in the first ferroelectric function layer is different from a doping concentration of the doping layer in the second ferroelectric function layer.

## Description

### TECHNICAL FIELD

This application relates to the field of chip technologies, and in particular, to a chip and a terminal.

### BACKGROUND

The advent of the era of big data brings higher requirements on information processing capabilities and information storage capacities. It is more difficult for the conventional von Neumann computer architecture and conventional memories to meet the requirements. Ferroelectric materials are used for the storage field because of their inherent advantages such as fast erase and write speeds, ultra-low power consumption, many cycles, and non-volatility of the polarization state. New non-volatile memories based on the ferroelectric materials, such as a ferroelectric random access memory (ferroelectric random access memory, FeRAM), a ferroelectric field effect transistor (ferroelectric field effect transistor, FeFET), and a ferroelectric tunneling junction (ferroelectric tunneling junction, FTJ) have attracted wide attention.

Common basic unit structures of components such as the ferroelectric random access memory, the ferroelectric field effect transistor, and the ferroelectric tunneling junction are metal-ferroelectric-metal (metal-ferroelectric-metal, MFM) structures. A work function of the first electrode and a work function of the second electrode may affect electrical symmetry and an on/off ratio of the foregoing component. For example, when the work function of the first electrode is different from the work function of the second electrode, the foregoing component has an electrical asymmetry problem. An internal electric field of the MFM structure may be accumulated with an external electric field, and the on/off ratio of the foregoing component is affected.

### SUMMARY

To resolve the foregoing technical problem, this application provides a chip and a terminal, to adjust electrical symmetry and an on/off ratio of a first electrode, a ferroelectric function layer, and a second electrode.

According to a first aspect, this application provides a chip. The chip includes the first electrode, a first ferroelectric function layer, a second ferroelectric function layer, and the second electrode that are sequentially stacked. The first ferroelectric function layer and the second ferroelectric function layer each include a ferroelectric oxide layer, the first ferroelectric function layer and/or the second ferroelectric function layer further include/includes a doping layer, electronegativity of the doping layer is different from electronegativity of the ferroelectric oxide layer, and a doping concentration of the doping layer in the first ferroelectric function layer is different from a doping concentration of the doping layer in the second ferroelectric function layer. The first electrode, the first ferroelectric function layer, the second ferroelectric function layer, and the second electrode form an MFM structure.

In this application, the doping concentration of the doping layer in the first ferroelectric function layer and the doping concentration of the doping layer in the second ferroelectric function layer may be adjusted based on a work function of the first electrode, a work function of the second electrode, and a relationship between the electronegativity of the doping layer and the electronegativity of the ferroelectric oxide layer, to form a second internal electric field between the first ferroelectric function layer and the second ferroelectric function layer. On one hand, the second internal electric field mainly locally exists on an interface between the first ferroelectric function layer and the second ferroelectric function layer, but does not act on an entire ferroelectric function layer, and therefore does not cause asymmetry of an entire MFM structure operated in an external electric field. On the other hand, when the work function of the first electrode is different from the work function of the second electrode, a first internal electric field that affects electrical symmetry of the MFM structure exists between the first electrode and the second electrode. Because a sum of the first internal electric field and the second internal electric field is directly proportional to a difference between the work functions of the first electrode and the second electrode, the existence of the second internal electric field reduces the first internal electric field, and reduces electrical asymmetry of the MFM structure caused by the first internal electric field. When the work function of the first electrode is the same as the work function of the second electrode, although no first internal electric field is formed between the first electrode and the second electrode, in this application, an on/off ratio between the first electrode and the second electrode may be further adjusted by using the second internal electric field between the first ferroelectric function layer and the second ferroelectric function layer. In addition, when the work functions of the first electrode and the second electrode are different, the on/off ratio between the first electrode and the second electrode may also be adjusted by using the second internal electric field between the first ferroelectric function layer and the second ferroelectric function layer.

In some possible implementations, if the work function of the first electrode is less than the work function of the second electrode, and the electronegativity of the doping layer is less than the electronegativity of the ferroelectric oxide layer, the doping concentration of the doping layer in the first ferroelectric function layer is greater than the doping concentration of the doping layer in the second ferroelectric function layer.

When the work function of the first electrode is less than the work function of the second electrode, the first internal electric field with a direction from the first electrode to the second electrode may be formed. As a result, a positive coercive field and a negative coercive field are asymmetric, and electrical asymmetry is caused. However, electrical performance of a unit component of most ferroelectric random access memories is positive-negative symmetric. Therefore, if an MFM structure with an asymmetric coercive field is used for a ferroelectric random access memory, problems of positive-negative erase and write asymmetry, incomplete reversal in a direction, and anti-interference asymmetry may occur in the ferroelectric random access memory. Based on this, the first ferroelectric function layer and/or the second ferroelectric function layer may include the doping layer, the electronegativity of the doping layer is less than the electronegativity of the ferroelectric oxide layer, and the doping concentration of the doping layer in the first ferroelectric function layer is greater than the doping concentration of the doping layer in the second ferroelectric function layer. A person skilled in the art should know that larger electronegativity indicates a stronger capability of electron absorption, and smaller electronegativity indicates a weaker capability of electron absorption. In addition, an electron is negative. Therefore, a capability of electron absorption of the second ferroelectric function layer is greater than a capability of electron absorption of the first ferroelectric function layer, and an electric dipole and the second internal electric field may be generated on a contact surface between the first ferroelectric function layer and the second ferroelectric function layer. Because the second ferroelectric function layer has the stronger capability of electron absorption, and a direction of the electric dipole is from the first ferroelectric function layer to the second ferroelectric function layer, a direction of the second internal electric field may be a direction from the first ferroelectric function layer to the second ferroelectric function layer. Although the second internal electric field and the first internal electric field have a same direction, on one hand, the second internal electric field mainly locally exists on the interface between the first ferroelectric function layer and the second ferroelectric function layer, but does not act on the entire ferroelectric function layer, and therefore does not cause the asymmetry of the entire MFM structure operated in the external electric field. On the other hand, because the sum of the first internal electric field and the second internal electric field is directly proportional to the difference between the work functions of the first electrode and the second electrode, the existence of the second internal electric field reduces the first internal electric field, and reduces the electrical asymmetry of the MFM structure caused by the first internal electric field.

In some possible implementations, an electric potential difference between the first electrode and the second electrode in the MFM structure may be further increased by adjusting the doping concentrations of the doping layers in the first ferroelectric function layer and the second ferroelectric function layer, to adjust the on/off ratio between the first electrode and the second electrode. For example, when the MFM structure is used for a ferroelectric tunneling junction, the on/off ratio between the first electrode and the second electrode may be adjusted when a voltage difference applied to the first electrode and the second electrode remains unchanged. In this case, if the work function of the first electrode is equal to the work function of the second electrode, and the electronegativity of the doping layer is less than the electronegativity of the ferroelectric oxide layer, the doping concentration of the doping layer in the first ferroelectric function layer is greater than the doping concentration of the doping layer in the second ferroelectric function layer.

Because the concentration of the doping layer in the first ferroelectric function layer is greater than the concentration of the doping layer in the second ferroelectric function layer, and the electronegativity of the doping layer is less than the electronegativity of the ferroelectric oxide layer, the capability of electron absorption of the second ferroelectric function layer is greater than the capability of electron absorption of the first ferroelectric function layer. The electric dipole and the second internal electric field may be generated on the contact surface between the first ferroelectric function layer and the second ferroelectric function layer. Because the second ferroelectric function layer has the stronger capability of electron absorption, and a direction of the electric dipole is from the first ferroelectric function layer to the second ferroelectric function layer, a direction of the second internal electric field may be a direction from the first ferroelectric function layer to the second ferroelectric function layer. If a direction of an external electric field is the same as the direction of the second internal electric field, the external electric field may be accumulated with the second internal electric field, so that the electric potential difference between the first electrode and the second electrode increases. In this way, if the external electric field is constant, an electric field actually experienced by the ferroelectric function layer may be increased, and this helps adjust the on/off ratio. In addition, the second internal electric field mainly locally exists on the interface between the first ferroelectric function layer and the second ferroelectric function layer, but does not act on the entire ferroelectric function layer, and therefore does not cause the asymmetry of the entire MFM structure operated in the external electric field.

In addition, for a different on/off ratio, the work function of the first electrode may be greater than the work function of the second electrode; or the work function of the first electrode may be less than the work function of the second electrode.

For the foregoing two possible implementations, when the concentration of the doping layer in the first ferroelectric function layer is greater than the concentration of the doping layer in the second ferroelectric function layer, the first ferroelectric function layer and the second ferroelectric function layer each include the doping layer; or the first ferroelectric function layer includes the doping layer, and the doping concentration of the doping layer in the second ferroelectric function layer is 0. To satisfy that the electronegativity of the doping layer is less than the electronegativity of the ferroelectric oxide layer, a material of the ferroelectric oxide layer includes HfO₂-ZrO₂, and a material of the doping layer includes at least one of La₂O₃, Y₂O₃, CeO₂, SrO, and Gd₂O₃.

In some possible implementations, if the work function of the first electrode is less than the work function of the second electrode, and the electronegativity of the doping layer is greater than the electronegativity of the ferroelectric oxide layer, the doping concentration of the doping layer in the first ferroelectric function layer is less than the doping concentration of the doping layer in the second ferroelectric function layer.

When the work function of the first electrode is less than the work function of the second electrode, the first internal electric field with a direction from the first electrode to the second electrode may be formed. As a result, a positive coercive field and a negative coercive field are asymmetric, and electrical asymmetry is caused. However, electrical performance of a unit component of most ferroelectric random access memories is positive-negative symmetric. Therefore, if an MFM structure with an asymmetric coercive field is used for a ferroelectric random access memory, problems of positive-negative erase and write asymmetry, incomplete reversal in a direction, and anti-interference asymmetry may occur in the ferroelectric random access memory. Based on this, the first ferroelectric function layer and/or the second ferroelectric function layer may include the doping layer, the electronegativity of the doping layer is greater than the electronegativity of the ferroelectric oxide layer, and the doping concentration of the doping layer in the first ferroelectric function layer is less than the doping concentration of the doping layer in the second ferroelectric function layer. A person skilled in the art should know that larger electronegativity indicates a stronger capability of electron absorption, and smaller electronegativity indicates a weaker capability of electron absorption. In addition, an electron is negative. Therefore, a capability of electron absorption of the second ferroelectric function layer is greater than a capability of electron absorption of the first ferroelectric function layer, and an electric dipole and the second internal electric field may be generated on a contact surface between the first ferroelectric function layer and the second ferroelectric function layer. Because the second ferroelectric function layer has the stronger capability of electron absorption, and a direction of the electric dipole is from the first ferroelectric function layer to the second ferroelectric function layer, a direction of the second internal electric field may be a direction from the first ferroelectric function layer to the second ferroelectric function layer. Although the second internal electric field and the first internal electric field have a same direction, on one hand, the second internal electric field mainly locally exists on the interface between the first ferroelectric function layer and the second ferroelectric function layer, but does not act on the entire ferroelectric function layer, and therefore does not cause the asymmetry of the entire MFM structure operated in the external electric field. On the other hand, because the sum of the first internal electric field and the second internal electric field is directly proportional to the difference between the work functions of the first electrode and the second electrode, the existence of the second internal electric field reduces the first internal electric field, and reduces the electrical asymmetry of the MFM structure caused by the first internal electric field.

In some possible implementations, an electric potential difference between the first electrode and the second electrode in the MFM structure may be further increased by adjusting the doping concentrations of the doping layers in the first ferroelectric function layer and the second ferroelectric function layer, to adjust the on/off ratio between the first electrode and the second electrode. For example, when the MFM structure is used for a ferroelectric tunneling junction, the on/off ratio between the first electrode and the second electrode may be adjusted when a voltage difference applied to the first electrode and the second electrode remains unchanged. In this case, if the work function of the first electrode is equal to the work function of the second electrode, and the electronegativity of the doping layer is greater than the electronegativity of the ferroelectric oxide layer, the doping concentration of the doping layer in the first ferroelectric function layer is less than the doping concentration of the doping layer in the second ferroelectric function layer.

Because the concentration of the doping layer in the first ferroelectric function layer is less than the concentration of the doping layer in the second ferroelectric function layer, and the electronegativity of the doping layer is greater than the electronegativity of the ferroelectric oxide layer, the capability of electron absorption of the second ferroelectric function layer is greater than the capability of electron absorption of the first ferroelectric function layer. The electric dipole and the second internal electric field may be generated on the contact surface between the first ferroelectric function layer and the second ferroelectric function layer. Because the second ferroelectric function layer has the stronger capability of electron absorption, and a direction of the electric dipole is from the first ferroelectric function layer to the second ferroelectric function layer, a direction of the second internal electric field may be a direction from the first ferroelectric function layer to the second ferroelectric function layer. If a direction of an external electric field is the same as the direction of the second internal electric field, the external electric field may be accumulated with the second internal electric field, so that the electric potential difference between the first electrode and the second electrode increases. In this way, if the external electric field is constant, an electric field actually experienced by the ferroelectric function layer may be increased, and this helps adjust the on/off ratio. In addition, the second internal electric field mainly locally exists on the interface between the first ferroelectric function layer and the second ferroelectric function layer, but does not act on the entire ferroelectric function layer, and therefore does not cause the asymmetry of the entire MFM structure operated in the external electric field.

In addition, for a different on/off ratio, the work function of the first electrode may be greater than the work function of the second electrode; or the work function of the first electrode may be less than the work function of the second electrode.

For the foregoing two possible implementations, when the concentration of the doping layer in the first ferroelectric function layer is less than the concentration of the doping layer in the second ferroelectric function layer, the first ferroelectric function layer and the second ferroelectric function layer each include the doping layer; or the doping concentration of the doping layer in the first ferroelectric function layer is 0, and the second ferroelectric function layer includes the doping layer. To satisfy that the electronegativity of the doping layer is greater than the electronegativity of the ferroelectric oxide layer, a material of the ferroelectric oxide layer includes HfO₂-ZrO₂, and the doping layer includes at least one of Al2O3, SiO2, Ga2O3, and GeO2.

In some possible implementations, the ferroelectric oxide layer usually includes quadrivalent hafnium and zirconium, and consequently, there are many oxygen vacancy defects in the ferroelectric oxide layer. In this application, an oxygen vacancy defect concentration in the ferroelectric oxide layer may be reduced by enabling the first ferroelectric function layer and/or the second ferroelectric function layer to include the doping layer, and the doping layer to include a material like trivalent lanthanum. Based on this, optionally, the first ferroelectric function layer and the second ferroelectric function layer each include the doping layer. In comparison with a solution in which the first ferroelectric function layer includes the doping layer and the second ferroelectric function layer does not include the doping layer, the first ferroelectric function layer and the second ferroelectric function layer each include the doping layer, and oxygen vacancy defect concentrations in both the first ferroelectric function layer and the second ferroelectric function layer decrease. When the MFM structure is used for the ferroelectric random access memory, the ferroelectric tunneling junction, or a ferroelectric field effect transistor, reliability parameters such as leakage, cycle life, and a retention characteristic of the ferroelectric random access memory, the ferroelectric tunneling junction, or the ferroelectric field effect transistor can be improved.

In some possible implementations, a ferroelectric field effect transistor and/or a two-dimensional capacitor structure are/or integrated in the chip. The first electrode, the ferroelectric function layer, and the second electrode are used as a gate of the ferroelectric field effect transistor; and/or the first electrode, the ferroelectric function layer, and the second electrode are used as the two-dimensional capacitor structure, the first electrode is a first pole of the two-dimensional capacitor structure, and the second electrode is a second pole of the two-dimensional capacitor structure. In this way, electrical symmetry or an on/off ratio of the ferroelectric field effect transistor and/or the two-dimensional capacitor structure may be adjusted in different cases.

In some possible implementations, a ferroelectric random access memory is integrated in the chip, the ferroelectric random access memory includes a plurality of capacitors and a plurality of plate lines, second poles of the plurality of capacitors are coupled to each other, and first poles of the plurality of capacitors are respectively coupled to different plate lines; and the chip includes a plurality of first electrodes and one second electrode, the plurality of first electrodes are used as the plurality of plate lines, and the second electrode is used as the second poles of the plurality of capacitors. In this way, electrical symmetry or an on/off ratio of a capacitor in the ferroelectric random access memory may be adjusted in different cases.

According to a second aspect, a chip is provided, and the chip includes a first electrode, a first ferroelectric function layer, a second ferroelectric function layer, and a second electrode that are sequentially stacked, where the first ferroelectric function layer and the second ferroelectric function layer each include a ferroelectric oxide layer, the first ferroelectric function layer further includes a first doping layer, the second ferroelectric function layer further includes a second doping layer, electronegativity of the first doping layer is different from electronegativity of the second doping layer, and each of the electronegativity of the first doping layer and the electronegativity of the second doping layer is different from electronegativity of the ferroelectric oxide layer. The first electrode, the first ferroelectric function layer, the second ferroelectric function layer, and the second electrode form an MFM structure.

In this application, a second internal electric field may be formed between the first ferroelectric function layer and the second ferroelectric function layer through adjustment based on the work function of the first electrode, the work function of the second electrode, and a relationship between the electronegativity of the first doping layer and the electronegativity of the second doping layer and the electronegativity of the ferroelectric oxide layer. On one hand, the second internal electric field mainly locally exists on an interface between the first ferroelectric function layer and the second ferroelectric function layer, but does not act on an entire ferroelectric function layer, and therefore does not cause asymmetry of an entire MFM structure operated in an external electric field. On the other hand, when the work function of the first electrode is different from the work function of the second electrode, a first internal electric field that affects electrical symmetry of the MFM structure exists between the first electrode and the second electrode. Because a sum of the first internal electric field and the second internal electric field is directly proportional to a difference between the work functions of the first electrode and the second electrode, the existence of the second internal electric field reduces the first internal electric field, and reduces electrical asymmetry of the MFM structure caused by the first internal electric field. When the work function of the first electrode is the same as the work function of the second electrode, although no first internal electric field is formed between the first electrode and the second electrode, in this application, an on/off ratio between the first electrode and the second electrode may be further adjusted by using the second internal electric field between the first ferroelectric function layer and the second ferroelectric function layer. In addition, when the work functions of the first electrode and the second electrode are different, the on/off ratio between the first electrode and the second electrode may also be adjusted by using the second internal electric field between the first ferroelectric function layer and the second ferroelectric function layer.

In some possible implementations, if the work function of the second electrode is greater than the work function of the first electrode, the electronegativity of the first doping layer is less than the electronegativity of the ferroelectric oxide layer, and the electronegativity of the second doping layer is greater than the electronegativity of the ferroelectric oxide layer.

When the work function of the first electrode is less than the work function of the second electrode, the first internal electric field with a direction from the first electrode to the second electrode may be formed. As a result, a positive coercive field and a negative coercive field are asymmetric, and electrical asymmetry is caused. However, electrical performance of a unit component of most ferroelectric random access memories is positive-negative symmetric. Therefore, if an MFM structure with an asymmetric coercive field is used for a ferroelectric random access memory, problems of positive-negative erase and write asymmetry, incomplete reversal in a direction, and anti-interference asymmetry may occur in the ferroelectric random access memory. Based on this, the first ferroelectric function layer may include the first doping layer, the second ferroelectric function layer may include the second doping layer, the electronegativity of the first doping layer may be less than the electronegativity of the ferroelectric oxide layer, and the electronegativity of the second doping layer may be greater than the electronegativity of the ferroelectric oxide layer. A person skilled in the art should know that larger electronegativity indicates a stronger capability of electron absorption, and smaller electronegativity indicates a weaker capability of electron absorption. In addition, an electron is negative. Therefore, a capability of electron absorption of the second ferroelectric function layer is greater than a capability of electron absorption of the first ferroelectric function layer, and an electric dipole and the second internal electric field may be generated on a contact surface between the first ferroelectric function layer and the second ferroelectric function layer. Because the second ferroelectric function layer has the stronger capability of electron absorption, and a direction of the electric dipole is from the first ferroelectric function layer to the second ferroelectric function layer, a direction of the second internal electric field may be a direction from the first ferroelectric function layer to the second ferroelectric function layer. Although the second internal electric field and the first internal electric field have a same direction, on one hand, the second internal electric field mainly locally exists on the interface between the first ferroelectric function layer and the second ferroelectric function layer, but does not act on the entire ferroelectric function layer, and therefore does not cause the asymmetry of the entire MFM structure operated in the external electric field. On the other hand, the sum of the first internal electric field and the second internal electric field is directly proportional to the difference between the work functions of the first electrode and the second electrode, the existence of the second internal electric field reduces the first internal electric field, and reduces the electrical asymmetry of the MFM structure caused by the first internal electric field.

In some possible implementations, an electric potential difference between the first electrode and the second electrode in the MFM structure may be further increased by adjusting the doping concentrations of the doping layers in the first ferroelectric function layer and the second ferroelectric function layer, to adjust the on/off ratio between the first electrode and the second electrode. For example, when the MFM structure is used for a ferroelectric tunneling junction, the on/off ratio between the first electrode and the second electrode may be adjusted when a voltage difference applied to the first electrode and the second electrode remains unchanged. In this case, if the work function of the second electrode is equal to the work function of the first electrode, the electronegativity of the first doping layer is less than the electronegativity of the ferroelectric oxide layer, and the electronegativity of the second doping layer is greater than the electronegativity of the ferroelectric oxide layer.

Because the first ferroelectric function layer includes the first doping layer, the second ferroelectric function layer includes the second doping layer, the electronegativity of the first doping layer is less than the electronegativity of the ferroelectric oxide layer, and the electronegativity of the second doping layer is greater than the electronegativity of the ferroelectric function layer, the capability of electron absorption of the second ferroelectric function layer is greater than the capability of electron absorption of the first ferroelectric function layer. The electric dipole and the second internal electric field may be generated on the contact surface between the first ferroelectric function layer and the second ferroelectric function layer. Because the second ferroelectric function layer has the stronger capability of electron absorption, and a direction of the electric dipole is from the first ferroelectric function layer to the second ferroelectric function layer, a direction of the second internal electric field may be a direction from the first ferroelectric function layer to the second ferroelectric function layer. If a direction of an external electric field is the same as the direction of the second internal electric field, the external electric field may be accumulated with the second internal electric field, so that the electric potential difference between the first electrode and the second electrode increases. In this way, if the external electric field is constant, an electric field actually experienced by the ferroelectric function layer may be increased, and this helps adjust the on/off ratio. In addition, the second internal electric field mainly locally exists on the interface between the first ferroelectric function layer and the second ferroelectric function layer, but does not act on the entire ferroelectric function layer, and therefore does not cause the asymmetry of the entire MFM structure operated in the external electric field.

In addition, for a different on/off ratio, the work function of the first electrode may be greater than the work function of the second electrode; or the work function of the first electrode may be less than the work function of the second electrode.

In some possible implementations, the ferroelectric oxide layer usually includes quadrivalent hafnium and zirconium, and consequently, there are many oxygen vacancy defects in the ferroelectric oxide layer. In this application, an oxygen vacancy defect concentration in the ferroelectric oxide layer may be reduced by enabling the first ferroelectric function layer and/or the second ferroelectric function layer to include the doping layer, and the doping layer to include a material like trivalent lanthanum. When the MFM structure is used for the ferroelectric random access memory, the ferroelectric tunneling junction, or a ferroelectric field effect transistor, reliability parameters such as leakage, cycle life, and a retention characteristic of the ferroelectric random access memory, the ferroelectric tunneling junction, or the ferroelectric field effect transistor can be improved.

For the foregoing two possible implementations, a material of the ferroelectric oxide layer includes HfO₂-ZrO₂, a material of the first doping layer includes at least one of La₂O₃, Y₂O₃, CeO₂, SiO, and Gd₂O₃, and the second doping layer includes at least one of Al₂O₃, SiO₂, Ga₂O₃, and GeO₂.

In some possible implementations, a ferroelectric field effect transistor and/or a two-dimensional capacitor structure are/is integrated in the chip. The first electrode, the ferroelectric function layer, and the second electrode are used as a gate of the ferroelectric field effect transistor; and/or the first electrode, the ferroelectric function layer, and the second electrode are used as the two-dimensional capacitor structure, the first electrode is a first pole of the two-dimensional capacitor structure, and the second electrode is a second pole of the two-dimensional capacitor structure. In this way, electrical symmetry or an on/off ratio of the ferroelectric field effect transistor and/or the two-dimensional capacitor structure may be adjusted in different cases.

In some possible implementations, a ferroelectric random access memory is integrated in the chip, the ferroelectric random access memory includes a plurality of capacitors and a plurality of plate lines, second poles of the plurality of capacitors are coupled to each other, and first poles of the plurality of capacitors are respectively coupled to different plate lines; and the chip includes a plurality of first electrodes and one second electrode, the plurality of first electrodes are used as the plurality of plate lines, and the second electrode is used as the second poles of the plurality of capacitors. In this way, electrical symmetry or an on/off ratio of a capacitor in the ferroelectric random access memory may be adjusted in different cases.

According to a third aspect, a terminal is provided, where the terminal includes a circuit board and the chip according to the first aspect or the second aspect, and the chip is disposed on the circuit board.

An implementation of the third aspect corresponds to any one of the implementations of the first aspect and the second aspect. For technical benefits corresponding to the implementation of the third aspect, refer to technical benefits corresponding to any one of the first aspect, the second aspect, and the implementations of the first aspect and the second aspect.

### BRIEF DESCRIPTION OF DRAWINGS

FIG. 1 is a diagram of a structure of an MFM structure according to a conventional technology;
FIG. 2a is a polarization state diagram of a ferroelectric function layer;
FIG. 2b is another polarization state diagram of a ferroelectric function layer;
FIG. 3a is a diagram of a structure of an MFM structure according to an embodiment of this application;
FIG. 3b is another diagram of a structure of an MFM structure according to an embodiment of this application;
FIG. 4a is still another diagram of a structure of an MFM structure according to an embodiment of this application;
FIG. 4b is still another diagram of a structure of an MFM structure according to an embodiment of this application;
FIG. 5a is an electric field analysis diagram of an MFM structure according to an embodiment of this application;
FIG. 5b is another electric field analysis diagram of an MFM structure according to an embodiment of this application;
FIG. 6a is a production process diagram of an MFM structure according to an embodiment of this application;
FIG. 6b is a production process diagram of an MFM structure according to an embodiment of this application;
FIG. 6c is a production process diagram of an MFM structure according to an embodiment of this application;
FIG. 6d is a production process diagram of an MFM structure according to an embodiment of this application;
FIG. 6e is a production process diagram of an MFM structure according to an embodiment of this application;
FIG. 6f is a production process diagram of an MFM structure according to an embodiment of this application;
FIG. 6g is a production process diagram of an MFM structure according to an embodiment of this application;
FIG. 7a is a circuit diagram of a ferroelectric random access memory according to an embodiment of this application;
FIG. 7b is still another diagram of a structure of an MFM structure according to an embodiment of this application;
FIG. 7c is a schematic cutaway view of an A-A' direction in FIG. 7b;
FIG. 7d is still another diagram of a structure of an MFM structure according to an embodiment of this application;
FIG. 7e is a schematic cutaway view of a B-B' direction in FIG. 7d;
FIG. 8a is a production process diagram of an MFM structure according to an embodiment of this application;
FIG. 8b is a production process diagram of an MFM structure according to an embodiment of this application;
FIG. 8c is a production process diagram of an MFM structure according to an embodiment of this application;
FIG. 8d is a production process diagram of an MFM structure according to an embodiment of this application;
FIG. 8e is a production process diagram of an MFM structure according to an embodiment of this application;
FIG. 8f is a production process diagram of an MFM structure according to an embodiment of this application;
FIG. 8g is a production process diagram of an MFM structure according to an embodiment of this application;
FIG. 9 is still another diagram of a structure of an MFM structure according to an embodiment of this application;
FIG. 10a is still another electric field analysis diagram of an MFM structure according to an embodiment of this application;
FIG. 10b is still another electric field analysis diagram of an MFM structure according to an embodiment of this application;
FIG. 10c is still another electric field analysis diagram of an MFM structure according to an embodiment of this application;
FIG. 10d is still another electric field analysis diagram of an MFM structure according to an embodiment of this application; and
FIG. 10e is still another electric field analysis diagram of an MFM structure according to an embodiment of this application.

### Reference numerals:

11-First electrode; 12-Second electrode; 20-Ferroelectric function layer; 21-First ferroelectric function layer; 211-First ferroelectric thin film; 22-Second ferroelectric function layer; 221-Second ferroelectric thin film; 30-Doping layer; 31-First doping layer; 32-Second doping layer; 301-First doping thin film; and 302-Second doping thin film.

### DESCRIPTION OF EMBODIMENTS

The following clearly and completely describes the technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and represents that three relationships may exist. For example, A and/or B may represent the following three cases: Only A exists, both A and B exist, and only B exists.

In the specification and claims in embodiments of this application, the terms "first", "second", and so on are intended to distinguish between different objects but do not indicate a particular order of the objects. For example, a first target object, a second target object, and the like are used for distinguishing between different target objects, but are not used for describing a specific order of the target objects.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word "example", "for example", or the like is intended to present a related concept in a specific manner.

In descriptions of embodiments of this application, unless otherwise stated, "plurality of" means two or more than two. For example, a plurality of processing units mean two or more processing units, and a plurality of systems mean two or more systems.

An embodiment of this application provides a terminal. The terminal may be a device including a chip, for example, a mobile phone, a computer, a tablet computer, a television, an in-vehicle display, or a smartwatch. Certainly, the terminal may alternatively be another device, and embodiments of this application do not limit a specific form of the terminal. For ease of description, the following provides descriptions by using an example in which the terminal is a mobile phone.

The mobile phone may include a memory, and the memory is configured to store instructions and data. For example, the memory may be configured to store computer executable program code, where the executable program code includes instructions. A processor of the mobile phone executes various function application and data processing of the mobile phone by running the instructions stored in the internal memory. For example, the processor of the mobile phone may generate an operation instruction for displaying a wallpaper and send the operation instruction to the server, and the memory may store the operation instruction.

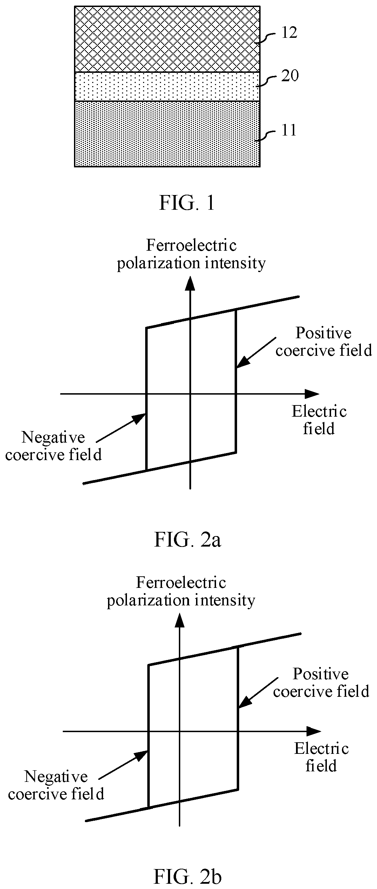

In some possible implementations, the memory may be a ferroelectric random access memory, where the ferroelectric random access memory may include one or more chips, and at least one capacitor is integrated in the one or more chips. The capacitor may be used as a ferroelectric component, and includes an MFM structure. As shown in FIG. 1, the MFM structure includes a first electrode 11, a ferroelectric function layer 20, and a second electrode 12 that are sequentially stacked. In other words, the MFM structure may be used as the capacitor of the ferroelectric random access memory.

It should be noted that, the foregoing descriptions in which the MFM structure may be used as the capacitor of the ferroelectric random access memory are merely an example. The MFM structure may alternatively be another component. This is not limited in embodiments of this application. For example, a ferroelectric field effect transistor includes a gate, and the gate includes the foregoing MFM structure. In addition, the first electrode 11, the ferroelectric function layer 20, and the second electrode 12 of the MFM structure, and an insulation layer and an active layer of the ferroelectric field effect transistor are sequentially stacked.

As shown in FIG. 2a, a voltage is applied to the first electrode 11 and the second electrode 12 to form an external electric field, and the external electric field enables the ferroelectric function layer 20 to generate a polarization state. Different from that internal polarization of a conventional dielectric material varies with the external electric field, internal polarization of the ferroelectric function layer 20 is in a non-linear relationship with the external electric field. In addition, due to directional polarization, two stable polarization states exist inside the ferroelectric function layer 20: a positive polarization state and a negative polarization state. A minimum voltage needed for a ferroelectric polarization state to change is a coercive field. An electric field for changing the positive polarization state to the negative polarization state is a negative coercive field, and an electric field for changing the negative polarization state to the positive polarization state is a positive coercive field. This lays a good foundation for a component with an MFM structure as a basic unit.

In some possible implementations, the first electrode 11 and the second electrode 12 may provide a stress for the ferroelectric function layer 20 by using a difference between respective thermal expansion coefficients, so that the ferroelectric function layer 20 generates a ferroelectric crystalline phase, and generates ferroelectricity. A material of the ferroelectric function layer 20 is not limited in embodiments of this application, provided that the ferroelectric function layer 20 can generate the ferroelectricity. Optionally, the material of the ferroelectric function layer 20 may include hafnium oxide. The hafnium oxide has advantages of excellent ferroelectricity and compatibility with a semiconductor process, and this also enables the ferroelectric component that is based on the hafnium oxide to have a good prospect of development.

To regulate strength of the ferroelectricity of the ferroelectric function layer 20, a person skilled in the art explores many different MFM structures, for example, the first electrode 11 and the second electrode 12 of different materials are used to clamp the ferroelectric function layer 20. However, as shown in FIG. 2b, work functions of the first electrode 11 and the second electrode 12 of the different materials are different. As a result, a positive coercive field and a negative coercive field of a ferroelectric polarization curve are asymmetric. Alternatively, the first electrode 11 and the second electrode 12 of a same material are used to clamp the ferroelectric function layer 20. However, a process parameter for forming the first electrode 11 is different from a process parameter for forming the second electrode 12, and this may also cause asymmetry between a positive coercive field and a negative coercive field. However, electrical performance of a unit component of most ferroelectric random access memories is positive-negative symmetric. Therefore, if an MFM structure with an asymmetric coercive field is used for a ferroelectric random access memory, problems of positive-negative erase and write asymmetry, incomplete reversal in a direction, and anti-interference asymmetry may occur in the ferroelectric random access memory.

In view of this, an embodiment of this application provides a chip. The chip includes the foregoing MFM structure. The work function of the first electrode 11 of the MFM structure is different from the work function of the second electrode 12. In this application, the ferroelectric function layer 20 is improved, so that the ferroelectric function layer 20 includes different first ferroelectric function layer 21 and second ferroelectric function layer 22, to resolve a problem of electrical asymmetry of the MFM structure caused by the different work functions of the first electrode 11 and the second electrode 12, and accurately control electrical performance of the MFM structure. The following describes a specific structure of the MFM structure with reference to the accompanying drawings.

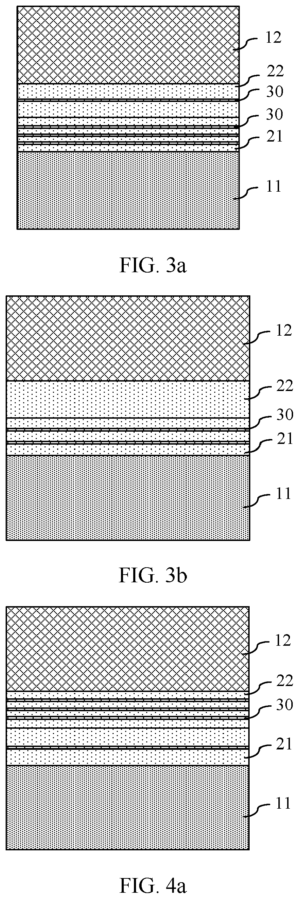

As shown in FIG. 3a to FIG. 4b, along a direction from the first electrode 11 to the second electrode 12, the first electrode 11, the first ferroelectric function layer 21, the second ferroelectric function layer 22, and the second electrode 12 are sequentially stacked. The first ferroelectric function layer 21 and the second ferroelectric function layer 22 each include a ferroelectric oxide layer, and the first ferroelectric function layer 21 and/or the second ferroelectric function layer 22 further include/includes a doping layer 30. Electronegativity of the doping layer 30 is different from electronegativity of the ferroelectric oxide layer, and a doping concentration of the doping layer 30 in the first ferroelectric function layer 21 is different from a doping concentration of the doping layer 30 in the second ferroelectric function layer 22.

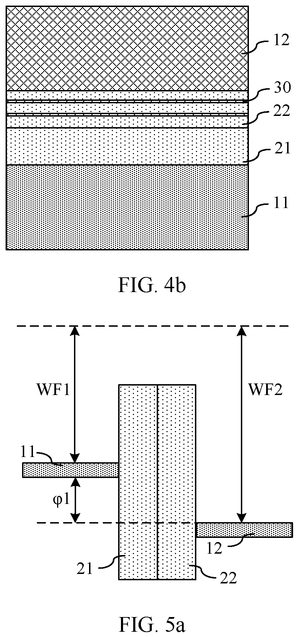

In an embodiment, as shown in FIG. 3a and FIG. 3b, if the work function WF1 of the first electrode 11 is less than the work function WF2 of the second electrode 12, a first internal electric field with a direction from the first electrode 11 to the second electrode 12 exists in the MFM structure, and a magnitude of the first internal electric field is directly proportional to a difference between the work functions of the first electrode 11 and the second electrode 12. The first internal electric field acts on the entire ferroelectric function layer 20, which is equivalent to that when no external electric field is applied, the ferroelectric function layer 20 already bears an electric field with a fixed direction and magnitude. This causes electrical asymmetry of the MFM structure under an external electric field operation. For example, as shown in FIG. 5a, in the first internal electric field, an electric potential difference between the first electrode 11 and the second electrode 12 is ϕ1. Based on this, the first ferroelectric function layer 21 and/or the second ferroelectric function layer 22 may further include the doping layer 30 other than the ferroelectric oxide layer.

In this embodiment of this application, the electronegativity of the doping layer 30 may be less than the electronegativity of the ferroelectric oxide layer, and the doping concentration of the doping layer 30 in the first ferroelectric function layer 21 is greater than the doping concentration of the doping layer 30 in the second ferroelectric function layer 22.

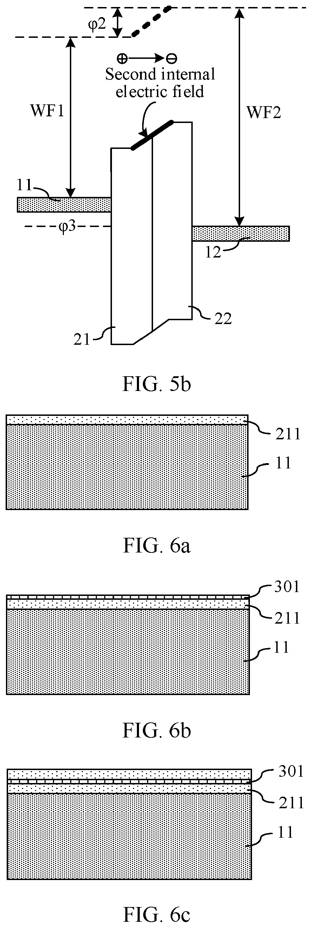

A person skilled in the art should know that larger electronegativity indicates a stronger capability of electron absorption, and smaller electronegativity indicates a weaker capability of electron absorption. In addition, an electron is negative. Because the concentration of the doping layer 30 in the first ferroelectric function layer 21 is greater than the concentration of the doping layer 30 in the second ferroelectric function layer 22, and the electronegativity of the doping layer 30 is less than the electronegativity of the ferroelectric oxide layer, a capability of electron absorption of the second ferroelectric function layer 22 is greater than a capability of electron absorption of the first ferroelectric function layer 21. As shown in FIG. 5b, an electric dipole and a second internal electric field may be generated on a contact surface between the first ferroelectric function layer 21 and the second ferroelectric function layer 22. Because the second ferroelectric function layer 22 has the stronger capability of electron absorption, and a direction of the electric dipole is from the first ferroelectric function layer 21 to the second ferroelectric function layer 22, a direction of the second internal electric field may be a direction from the first ferroelectric function layer 21 to the second ferroelectric function layer 22. Although the second internal electric field and the first internal electric field have a same direction, on one hand, the second internal electric field mainly locally exists on the interface between the first ferroelectric function layer 21 and the second ferroelectric function layer 22, but does not act on the entire ferroelectric function layer 20, and therefore does not cause the asymmetry of the entire MFM structure operated in the external electric field. On the other hand, because a sum of the first internal electric field and the second internal electric field is directly proportional to the difference between the work functions of the first electrode 11 and the second electrode 12, the existence of the second internal electric field reduces the first internal electric field, and reduces the electrical asymmetry of the MFM structure caused by the first internal electric field.

In this way, as shown in FIG. 5a and FIG. 5b, the second internal electric field is adjusted by adjusting a concentration difference between the doping layer 30 in the first ferroelectric function layer 21 and the doping layer 30 in the second ferroelectric function layer 22. For example, in the second internal electric field, an electric potential difference between the first ferroelectric function layer 21 and the second ferroelectric function layer 22 is ϕ2. The second internal electric field is used to neutralize the first internal electric field, so that an electric potential difference of the first internal electric field is reduced to ϕ3, where ϕ3 = ϕ1 - ϕ2. In this way, the problem of the electrical asymmetry caused by the different work functions of the first electrode 11 and the second electrode 12 is resolved, symmetry of the MFM structure is improved, and the electrical performance of the MFM structure is accurately controlled. The problems of the positive-negative erase and write asymmetry, the incomplete reversal in a direction, and the anti-interference asymmetry that occur when the MFM structure is used for the ferroelectric random access memory are avoided.

In some possible implementations, the doping concentration of the doping layer 30 in the first ferroelectric function layer 21 and the doping concentration of the doping layer 30 in the second ferroelectric function layer 22 are not limited in embodiments of this application, and the doping concentration of the doping layer 30 in the first ferroelectric function layer 21 and the doping concentration of the doping layer 30 in the second ferroelectric function layer 22 are related to the difference between the work functions of the first electrode 11 and the second electrode 12 and a degree of adjustment that a person skilled in the art wants to perform on asymmetry of the MFM structure. Optionally, in this embodiment, the doping concentration of the doping layer 30 in the first ferroelectric function layer 21 may be (0 mol%, 25 mol%], the doping concentration of the doping layer 30 in the second ferroelectric function layer 22 may be [0 mol%, 25 mol%), and the doping concentration of the doping layer 30 in the first ferroelectric function layer 21 is greater than the doping concentration of the doping layer 30 in the second ferroelectric function layer 22.

For example, a material of the first electrode 11 may include tungsten (W) produced by using a physical vapor deposition (physical vapor deposition, PVD) method, a material of the second electrode 12 may include titanium nitride (TiN) produced by using an atomic layer deposition (atomic layer deposition, ALD) method, a total thickness of the ferroelectric function layer 20 is 10 nm, and a thickness of the first ferroelectric function layer 21 and a thickness of the second ferroelectric function layer 22 are both 5 nm. A material of the ferroelectric oxide layer may include hafnium zirconium oxide (HfO₂-ZrO₂, HZO), and a material of the doping layer 30 may include lanthanum oxide (La₂O₃). A work function WF1 of tungsten is 4.55 eV, a work function WF2 of titanium nitride is 5.27 eV, and a direction of the first internal electric field is from the first electrode 11 to the second electrode 12. In addition, because electronegativity of lanthanum is less than electronegativity of hafnium and zirconium, a total concentration of lanthanum oxide in the first ferroelectric function layer 21, that is, hafnium zirconium oxide close to a tungsten side, may be 2.4 mol%, and a total concentration of lanthanum oxide in the second ferroelectric function layer 22, that is, hafnium zirconium oxide close to a titanium nitride side, may be 0.8 mol%, to form the second internal electric field with a direction from the first ferroelectric function layer 21 to the second ferroelectric function layer 22. The second internal electric field is used to neutralize the first internal electric field, so as to resolve an electrical asymmetry problem caused by the different work functions of tungsten and titanium nitride.

Certainly, due to existence of the first ferroelectric function layer 21 and the second ferroelectric function layer 22, the electrical asymmetry of the MFM structure may be adjusted by adjusting the doping concentrations of the doping layers 30 in the first ferroelectric function layer 21 and the second ferroelectric function layer 22. Therefore, specific materials of the first electrode 11 and the second electrode 12 are not limited in embodiments of this application. Optionally, the material of the first electrode 11 is different from the material of the second electrode 12, and different conductive materials cause the work functions of the first electrode 11 and the second electrode 12 to be different. Optionally, the material of the first electrode 11 may be the same as the material of the second electrode 12, but a production manner of producing the first electrode 11 is different from a production manner of producing the second electrode 12. The foregoing production manner includes a production process and a process parameter. For example, the manners of producing the first electrode 11 and the second electrode 12 may include physical vapor deposition, chemical vapor deposition (chemical vapor deposition, CVD), atomic layer deposition, and the like. The second electrode 12 including titanium nitride has different work functions when produced by using the atomic layer deposition method and the physical vapor deposition method. The second electrode 12 including titanium nitride also has different work functions when produced by using the atomic layer deposition method at different production temperatures.

For example, the materials of the first electrode 11 and the second electrode 12 may include at least one of TiN, tantalum nitride (TaN), hafnium nitride (HfN), zirconium nitride (ZrN), tungsten nitride (WN), titanium silicon nitride (TiSiN), titanium carbo-nitride (TiCN), W, ruthenium (Ru), molybdenum (Mo), iridium (Ir), nickel (Ni), platinum (Pt), ruthenium oxide (RuO), iridium oxide (IrO₂), indium tin oxide (indium tin oxide, ITO), strontium titanate (strontium titanate oxide, STO), and lanthanum strontium manganese oxide (LSMO).

It should be noted herein that, although the first electrode 11 and the second electrode 12 may each include at least one of the foregoing materials, in actual application, the material of the first electrode 11 should be different from the material of the second electrode 12; or the material of the first electrode 11 is the same as the material of the second electrode 12, but the production manner of forming the first electrode 11 is different from the production manner of forming the second electrode 12, so that the work function WF1 of the first electrode 11 is less than the work function WF2 of the second electrode 12.

Similarly, specific materials of the ferroelectric oxide layer and the doping layer 30 are not limited in embodiments of this application, provided that the electronegativity of the doping layer 30 is less than the electronegativity of the ferroelectric oxide layer.

For example, the doping layer 30 includes at least one of lanthanum oxide, yttrium oxide (Y₂O₃), cerium oxide (CeO₂), strontium oxide (SrO), and gadolinium oxide (Gd₂O₃), and the ferroelectric oxide layer includes hafnium zirconium oxide. Alternatively, the doping layer 30 includes at least one of silicon dioxide (SiO₂), aluminum oxide (Al₂O₃), lanthanum oxide, yttrium oxide, gadolinium oxide, and strontium oxide, and the ferroelectric oxide layer includes hafnium dioxide (HfO₂).

In addition, for whether the first ferroelectric function layer 21 and the second ferroelectric function layer 22 include the doping layer 30, in some possible implementations, as shown in FIG. 3a, the first ferroelectric function layer 21 and the second ferroelectric function layer 22 may each include the doping layer 30, and a total doping concentration of the doping layer 30 in the first ferroelectric function layer 21 is greater than the doping concentration of the doping layer 30 in the second ferroelectric function layer. In some other possible implementations, as shown in FIG. 3b, the first ferroelectric function layer 21 may include the doping layer 30, and the second ferroelectric function layer 22 may not include the doping layer 30, so that the doping concentration of the doping layer 30 in the first ferroelectric function layer 21 is greater than the doping concentration of the doping layer 30 in the second ferroelectric function layer 22.

Because hafnium and zirconium are quadrivalent, there are many oxygen vacancy defects in the ferroelectric oxide layer. In this application, an oxygen vacancy defect concentration in the ferroelectric oxide layer may be reduced by enabling the first ferroelectric function layer 21 and/or the second ferroelectric function layer 22 to include the doping layer 30, and the doping layer 30 to include a material like trivalent lanthanum. Optionally, in comparison with a solution in which the first ferroelectric function layer 21 includes the doping layer 30 and the second ferroelectric function layer 22 does not include the doping layer 30, when the first ferroelectric function layer 21 and the second ferroelectric function layer 22 each include the doping layer 30, and the doping layer 30 includes a trivalent doping material (for example, lanthanum oxide), an oxygen vacancy defect concentration in each of the first ferroelectric function layer 21 and the second ferroelectric function layer 22 decreases. When the MFM structure is used for the ferroelectric random access memory, the ferroelectric tunneling junction, or a ferroelectric field effect transistor, reliability parameters such as leakage, cycle life, and a retention characteristic of the ferroelectric random access memory, the ferroelectric tunneling junction, or the ferroelectric field effect transistor can be improved.

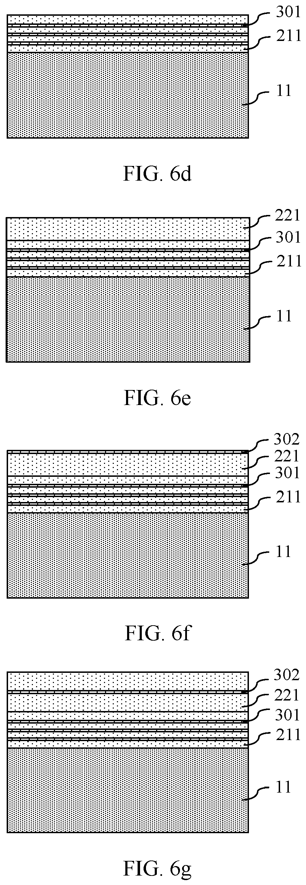

In addition, refer to FIG. 6g. A ferroelectric oxide layer of the first ferroelectric function layer 21 includes at least one first ferroelectric thin film 211, and a ferroelectric oxide layer of the second ferroelectric function layer 22 includes at least one second ferroelectric thin film 212. An existence form of the doping layers 30 in the first ferroelectric function layer 21 and the second ferroelectric function layer 22 is not limited in embodiments of this application.

Optionally, as shown in FIG. 3b and FIG. 6g, when the first ferroelectric function layer 21 includes the doping layer 30, and the second ferroelectric function layer 22 does not include the doping layer 30, the doping layer 30 in the first ferroelectric function layer 21 may include at least one first doping thin film 301. The first ferroelectric thin film 211 and the first doping thin film 301 are alternately stacked along a direction from the first electrode 11 to the second electrode 22.

In some possible implementations, an atomic layer deposition process may be used to form the first ferroelectric thin film 211, the first doping thin film 301, and the second ferroelectric thin film 221. Each first ferroelectric thin film 211, each second ferroelectric thin film 221, and each first doping thin film 301 are separate thin films respectively, and the first ferroelectric thin film 211 does not include a material of the first doping thin film 301.

Optionally, as shown in FIG. 3a and FIG. 6g, when the first ferroelectric function layer 21 and the second ferroelectric function layer 22 each include the doping layer 30, the doping layer 30 in the first ferroelectric function layer 21 may include at least one first doping thin film 301, and the doping layer 30 in the second ferroelectric function layer 22 may include at least one second doping thin film 302. Along a direction from the first electrode 11 to the second electrode 22, the first ferroelectric thin film 211 and the first doping thin film 301 are alternately stacked, and the second ferroelectric thin film 221 and the second doping thin film 302 are alternately stacked.

In some possible implementations, the atomic layer deposition process may be used to form the first ferroelectric thin film 211, the first doping thin film 301, the second ferroelectric thin film 221, and the second doping thin film 302. Each first ferroelectric thin film 211, each second ferroelectric thin film 221, each first doping thin film 301, and each second doping thin film 302 are separate thin films respectively, the first ferroelectric thin film 211 does not include the material of the first doping thin film 301, and the second ferroelectric thin film 221 does not include a material of the second doping thin film 302.

In some possible implementations, when a total thickness of the first ferroelectric function layer 21 is the same as a total thickness of the second ferroelectric function layer 22, a doping concentration of one first doping thin film 301 in the first ferroelectric function layer 21 may be the same as a doping concentration of one second doping thin film 302 in the second ferroelectric function layer 22. A quantity of first doping thin films 301 is enabled to be greater than a quantity of second doping thin films 302, so that a total doping concentration of all the first doping thin films 301 is greater than a total doping concentration of all the second doping thin films 302. Certainly, the thickness of the first ferroelectric function layer 21 may be different from the thickness of the second ferroelectric function layer 22, provided that the doping concentration of the doping layer 30 in the first ferroelectric function layer 21 is greater than the doping concentration of the doping layer 30 in the second ferroelectric function layer 22.

An example in which a total thickness of the ferroelectric function layer 20 is 10 nm, and the thicknesses of the first ferroelectric function layer 21 and the second ferroelectric function layer 22 are the same is used. A thickness range of the first ferroelectric thin film 211 may be 0.8 nm to 1.2 nm. For example, a thickness of the first ferroelectric thin film 211 is 0.8 nm, 1 nm, or 1.2 nm. A thickness range of the second ferroelectric thin film 221 may be 3 nm to 4 nm. For example, a thickness of the second ferroelectric thin film 221 is 3 nm, 3.4 nm, or 4 nm. Thickness ranges of the first doping thin film 301 and the second doping thin film 302 may be 0.08 nm to 0.12 nm. For example, thicknesses of the first doping thin film 301 and the second doping thin film 302 are 0.08 nm, 0.1 nm, or 0.12 nm.

Certainly, the total thickness of the ferroelectric function layer 20 may be another value. Optionally, the total thickness of the ferroelectric function layer 20 may be 2 nm to 30 nm. For example, the total thickness of the ferroelectric function layer 20 is 2 nm, 4 nm, 12 nm, 20 nm, 26 nm, or 30 nm. In this case, quantities of first ferroelectric thin films 211, second ferroelectric thin films 221, first doping thin films 301, and second doping thin films 302 may remain unchanged, but thicknesses decrease or increase with the total thickness of the ferroelectric function layer 20.

The following uses an example in which the first ferroelectric function layer 21 and the second ferroelectric function layer 22 each include the doping layer 30, to describe a production process of the first ferroelectric function layer 21 and the second ferroelectric function layer 22. As shown in FIG. 6a, the first ferroelectric thin film 211 is formed on the first electrode 11. As shown in FIG. 6b, the first ferroelectric thin film 301 is formed on a side that is of the first ferroelectric thin film 211 and that faces away from the first electrode 11. As shown in FIG. 6c, the first ferroelectric thin film 211 is formed again on a side that is of the first doping thin film 301 and that faces away from the first electrode 11. As shown in FIG. 6d, the foregoing steps of forming the first doping thin film 301 and the first ferroelectric thin film 211 are repeated in sequence until the first ferroelectric function layer 21 is formed. Then, as shown in FIG. 6e, the second ferroelectric thin film 221 is formed on a side that is of the first ferroelectric function layer 21 and that faces away from the first electrode 11. As shown in FIG. 6f, the second doping thin film 302 is formed on a side that is of the second ferroelectric thin film 221 and that faces away from the first electrode 11. As shown in FIG. 6g, the second ferroelectric thin film 221 is formed on a side that is of the second doping thin film 302 and that faces away from the first electrode 11, to obtain the second ferroelectric function layer 22.

Certainly, the foregoing production process is described by using an example in which the first ferroelectric function layer 21 and the second ferroelectric function layer 22 are sequentially formed on the first electrode 11. In embodiments of this application, the second ferroelectric function layer 22 and the first ferroelectric function layer 21 may alternatively be sequentially formed on the second electrode 12. In addition, if the first ferroelectric function layer 21 includes the doping layer 30, and the second ferroelectric function layer 22 does not include the doping layer 30, the first ferroelectric function layer 21 may be formed by using steps corresponding to FIG. 6a to FIG. 6d. Then, the second ferroelectric thin film 221 is directly formed on the side that is of the first ferroelectric function layer 21 and that is away from the first electrode 11, to obtain the second ferroelectric function layer 22.

In addition, the foregoing production process is described by using an example in which the first ferroelectric function layer 21 includes a plurality of first doping thin films 301, and the second ferroelectric function layer 22 includes one second doping thin film 302. Alternatively, there may be another quantity of first doping thin films 301 and another quantity of second doping thin films 302. This is not limited in embodiments of this application. A relationship between a quantity of first doping thin films 301 and a quantity of second doping thin films 302 is related to electric field strength of the first internal electric field formed by the first electrode 11 and the second electrode 12, and doping concentrations of each first doping thin film 301 and each second doping thin film 302. In embodiments of this application, the quantity of first doping thin films 301 and the quantity of second doping thin films 302 may be adjusted based on an actual situation.

The foregoing embodiment is described by using an example in which the work function WF1 of the first electrode 11 is less than the work function WF2 of the second electrode 12. In some other possible implementations, if the work function of the first electrode 11 is greater than the work function of the second electrode 12, when the electronegativity of the doping layer 30 is less than the electronegativity of the ferroelectric oxide layer, the doping concentration of the doping layer 30 in the first ferroelectric function layer 21 may be less than the doping concentration of the doping layer 30 in the second ferroelectric function layer 22.

In some possible implementations, in actual application, as shown in FIG. 3a and FIG. 3b, the MFM structure in embodiments of this application may be used as a two-dimensional capacitor structure, the first electrode 11 of the MFM structure may be a first pole of the two-dimensional capacitor structure, and the second electrode 12 may be a second pole of the two-dimensional capacitor structure.

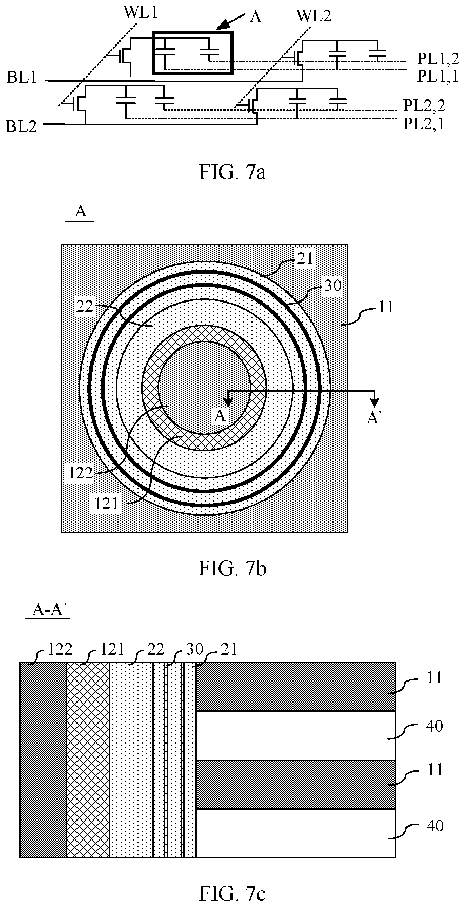

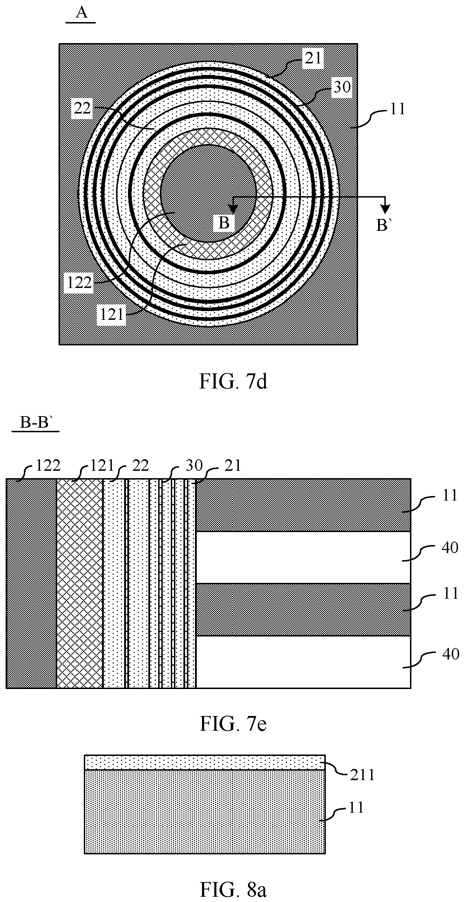

Alternatively, as shown in 7a, when the MFM structure is used for a ferroelectric random access memory of a three-dimensional structure, the ferroelectric random access memory includes a plurality of capacitors and a plurality of plate lines (plate lines, PLs), the capacitor includes a first pole and a second pole, first poles of the plurality of capacitors are respectively coupled to different plate lines (for example, PL1,1 and PL 1,2), and second poles of the plurality of capacitors are coupled to each other. As shown in FIG. 7b to FIG. 7e, the MFM structure may include a plurality of capacitors and a plurality of plate lines that are respectively coupled to the plurality of capacitors. Specifically, the MFM structure includes a plurality of first electrodes 11 and one second electrode 12. Each first electrode 11 is reused as a first pole of one plate line and one capacitor in the ferroelectric random access memory. The second electrode 12 may be used as second poles of the plurality of capacitors, and the second poles of the plurality of capacitors are coupled to each other. The first ferroelectric function layer 21 and the second ferroelectric function layer 22 may be disposed between the plurality of plate lines and a second pole of one capacitor. The material of the first electrode 11 may include tungsten, and resistance of a plate line may be reduced by using tungsten, to reduce an RC delay in the ferroelectric random access memory. The second electrode 12 may include a columnar first sub-electrode 121 and a second sub-electrode 122, and a material of the second sub-electrode 122 may include tungsten. However, because a depth of the columnar second electrode 12 is large, it is difficult to deposit by using the physical vapor deposition method. If the chemical vapor deposition method is used for deposition, tungsten in the second sub-electrode 122 cannot be attached to a surface of the ferroelectric oxide layer. Therefore, the first sub-electrode 121 is further disposed between the second sub-electrode 122 and the ferroelectric oxide layer, and a material of the first sub-electrode 121 includes titanium nitride. In this way, the first internal electric field of the MFM structure used for the ferroelectric random access memory of the three-dimensional structure may be reduced by using the first ferroelectric function layer 21 and the second ferroelectric function layer 22, to gain improvement for an electrical asymmetry problem of the ferroelectric random access memory of the three-dimensional structure.

In another embodiment, as shown in FIG. 4a and FIG. 4b, if the work function WF1 of the first electrode 11 is less than the work function WF2 of the second electrode 12, a first internal electric field from the first electrode 11 to the second electrode 12 exists in the MFM structure, and a magnitude of the first internal electric field is directly proportional to a difference between the work functions of the first electrode 11 and the second electrode 12. The first internal electric field acts on the entire ferroelectric function layer 20, which is equivalent to that when no external electric field is applied, the ferroelectric function layer 20 already bears an electric field with a fixed direction and magnitude. This causes electrical asymmetry of the MFM structure. For example, as shown in FIG. 5a, in the first internal electric field, an electric potential difference between the first electrode 11 and the second electrode 12 is ϕ1. Based on this, the first ferroelectric function layer 21 and/or the second ferroelectric function layer 22 may further include a doping layer 30 other than the ferroelectric oxide layer.

In this embodiment of this application, the electronegativity of the doping layer 30 may be greater than the electronegativity of the ferroelectric oxide layer, and the doping concentration of the doping layer 30 in the first ferroelectric function layer 21 is less than the doping concentration of the doping layer 30 in the second ferroelectric function layer 22.

A person skilled in the art should know that larger electronegativity indicates a stronger capability of electron absorption, and smaller electronegativity indicates a weaker capability of electron absorption. In addition, an electron is negative. Because the concentration of the doping layer 30 in the first ferroelectric function layer 21 is less than the concentration of the doping layer 30 in the second ferroelectric function layer 22, and the electronegativity of the doping layer 30 is greater than the electronegativity of the ferroelectric oxide layer, a capability of electron absorption of the second ferroelectric function layer 22 is greater than a capability of electron absorption of the first ferroelectric function layer 21. As shown in FIG. 5b, an electric dipole and a second internal electric field may be generated on a contact surface between the first ferroelectric function layer 21 and the second ferroelectric function layer 22. Because the second ferroelectric function layer 22 has the stronger capability of electron absorption, and a direction of the electric dipole is from the first ferroelectric function layer 21 to the second ferroelectric function layer 22, a direction of the second internal electric field may be a direction from the first ferroelectric function layer 21 to the second ferroelectric function layer 22. Although the second internal electric field and the first internal electric field have a same direction, on one hand, the second internal electric field mainly locally exists on the interface between the first ferroelectric function layer 21 and the second ferroelectric function layer 22, but does not act on the entire ferroelectric function layer 20, and therefore does not cause the asymmetry of the entire MFM structure operated in the external electric field. On the other hand, because a sum of the first internal electric field and the second internal electric field is directly proportional to the difference between the work functions of the first electrode 11 and the second electrode 12, the existence of the second internal electric field reduces the first internal electric field, and reduces the electrical asymmetry of the MFM structure caused by the first internal electric field.

In this way, as shown in FIG. 5a and FIG. 5b, the second internal electric field is adjusted by adjusting a concentration difference between the doping layer 30 in the first ferroelectric function layer 21 and the doping layer 30 in the second ferroelectric function layer 22. For example, in the second internal electric field, an electric potential difference between the first ferroelectric function layer 21 and the second ferroelectric function layer 22 is ϕ2. The second internal electric field is used to neutralize the first internal electric field, so that an electric potential difference of the first internal electric field is reduced to ϕ3, where ϕ3 = ϕ1 - ϕ2. In this way, the problem of the electrical asymmetry caused by the different work functions of the first electrode 11 and the second electrode 12 is resolved, symmetry of the MFM structure is improved, and the electrical performance of the MFM structure is accurately controlled. The problems of the positive-negative erase and write asymmetry, the incomplete reversal in a direction, and the anti-interference asymmetry that occur when the MFM structure is used for the ferroelectric random access memory are avoided.

In some possible implementations, the doping concentration of the doping layer 30 in the first ferroelectric function layer 21 and the doping concentration of the doping layer 30 in the second ferroelectric function layer 22 are not limited in embodiments of this application, and the doping concentration of the doping layer 30 in the first ferroelectric function layer 21 and the doping concentration of the doping layer 30 in the second ferroelectric function layer 22 are related to the difference between the work functions of the first electrode 11 and the second electrode 12 and a degree of adjustment that a person skilled in the art wants to perform on asymmetry of the MFM structure. Optionally, in this embodiment, the doping concentration of the doping layer 30 in the first ferroelectric function layer 21 may be [0 mol%, 25 mol%), the doping concentration of the doping layer 30 in the second ferroelectric function layer 22 may be (0 mol%, 25 mol%], and the doping concentration of the doping layer 30 in the first ferroelectric function layer 21 is less than the doping concentration of the doping layer 30 in the second ferroelectric function layer 22.

For example, a material of the first electrode 11 may include tungsten produced by using a physical vapor deposition method, a material of the second electrode 12 may include titanium nitride produced by using an atomic layer deposition method, a total thickness of the ferroelectric function layer 20 is 10 nm, and a thickness of the first ferroelectric function layer 21 and a thickness of the second ferroelectric function layer 22 are both 5 nm. A material of the ferroelectric oxide layer may include hafnium zirconium oxide, and a material of the doping layer 30 may include aluminum oxide. A work function WF1 of tungsten is 4.55 eV, a work function WF2 of titanium nitride is 5.27 eV, and a direction of the first internal electric field is from the first electrode 11 to the second electrode 12. In addition, because electronegativity of aluminum is greater than electronegativity of hafnium and zirconium, a total concentration of aluminum oxide in the first ferroelectric function layer 21, that is, hafnium zirconium oxide close to a tungsten side, may be 0.8 mol%, and a total concentration of aluminum oxide in the second ferroelectric function layer 22, that is, hafnium zirconium oxide close to a titanium nitride side, may be 2.4 mol%, to form the second internal electric field with a direction from the first ferroelectric function layer 21 to the second ferroelectric function layer 22, and resolve an electrical asymmetry problem caused by the different work functions of tungsten and titanium nitride.

Certainly, due to existence of the first ferroelectric function layer 21 and the second ferroelectric function layer 22, the electrical asymmetry of the MFM structure may be adjusted by adjusting the doping concentrations of the doping layers 30 in the first ferroelectric function layer 21 and the second ferroelectric function layer 22. Therefore, specific materials of the first electrode 11 and the second electrode 12 are not limited in embodiments of this application. Descriptions of the materials of the first electrode 11 and the second electrode 12 are the same as the descriptions of the materials of the first electrode 11 and the second electrode 12 in the foregoing embodiment, and details are not described herein again.

Similarly, specific materials of the ferroelectric oxide layer and the doping layer 30 are not limited in embodiments of this application, provided that the electronegativity of the doping layer 30 is greater than the electronegativity of the ferroelectric oxide layer.

For example, the doping layer 30 includes at least one of aluminum oxide, silicon dioxide, gallium oxide (Ga₂O₃), and germanium oxide (GeO₂), and the ferroelectric oxide layer includes hafnium zirconium oxide.

In addition, for whether the first ferroelectric function layer 21 and the second ferroelectric function layer 22 include the doping layer 30, in some possible implementations, as shown in FIG. 4a, the first ferroelectric function layer 21 and the second ferroelectric function layer 22 may each include the doping layer 30, and a total doping concentration of the doping layer 30 in the first ferroelectric function layer 21 is less than the doping concentration of the doping layer 30 in the second ferroelectric function layer 22. In some other possible implementations, as shown in FIG. 4b, the first ferroelectric function layer 21 may not include the doping layer 30, and the second ferroelectric function layer 22 may include the doping layer 30, so that the doping concentration of the doping layer 30 in the first ferroelectric function layer 21 is less than the doping concentration of the doping layer 30 in the second ferroelectric function layer 22.

Because hafnium and zirconium are quadrivalent, there are many oxygen vacancy defects in the ferroelectric oxide layer. In this application, an oxygen vacancy defect concentration in the ferroelectric oxide layer may be reduced by enabling the first ferroelectric function layer 21 and/or the second ferroelectric function layer 22 to include the doping layer 30, and the doping layer 30 to include a material like trivalent lanthanum. Optionally, in comparison with a solution in which the first ferroelectric function layer 21 does not include the doping layer 30 and the second ferroelectric function layer 22 includes the doping layer 30, when the first ferroelectric function layer 21 and the second ferroelectric function layer 22 each include the doping layer 30, and the doping layer 30 includes a trivalent doping material (for example, aluminum oxide), an oxygen vacancy defect concentration in each of the first ferroelectric function layer 21 and the second ferroelectric function layer 22 decreases. When the MFM structure is used for the ferroelectric random access memory, the ferroelectric tunneling junction, or a ferroelectric field effect transistor, reliability parameters such as leakage, cycle life, and a retention characteristic of the ferroelectric random access memory, the ferroelectric tunneling junction, or the ferroelectric field effect transistor can be improved.

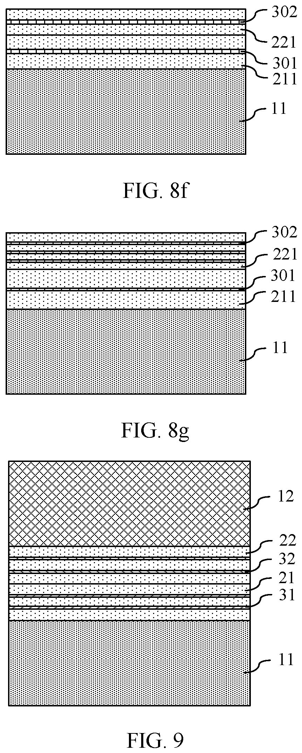

In addition, refer to FIG. 8g. A ferroelectric oxide layer of the first ferroelectric function layer 21 includes at least one first ferroelectric thin film 211, and a ferroelectric oxide layer of the second ferroelectric function layer 22 includes at least one second ferroelectric thin film 212. An existence form of the doping layers 30 in the first ferroelectric function layer 21 and the second ferroelectric function layer 22 is not limited in embodiments of this application.

Optionally, as shown in FIG. 4b and FIG. 8g, when the second ferroelectric function layer 22 includes the doping layer 30, and the first ferroelectric function layer 21 does not include the doping layer 30, the doping layer 30 in the second ferroelectric function layer 22 may include at least one first doping thin film 301. The second ferroelectric thin film 221 and the second doping thin film 302 are alternately stacked along a direction from the first electrode 11 to the second electrode 22.

In some possible implementations, an atomic layer deposition process may be used to form the first ferroelectric thin film 211, the first doping thin film 301, and the second ferroelectric thin film 221. Each first ferroelectric thin film 211, each second ferroelectric thin film 221, and each first doping thin film 301 are separate thin films respectively, and the first ferroelectric thin film 211 does not include a material of the first doping thin film 301.

Optionally, as shown in FIG. 4a and FIG. 8g, when the first ferroelectric function layer 21 and the second ferroelectric function layer 22 each include the doping layer 30, the doping layer 30 in the first ferroelectric function layer 21 may include at least one first doping thin film 301, and the doping layer 30 in the second ferroelectric function layer 22 may include at least one second doping thin film 302. Along a direction from the first electrode 11 to the second electrode 22, the first ferroelectric thin film 211 and the first doping thin film 301 are alternately stacked, and the second ferroelectric thin film 221 and the second doping thin film 302 are alternately stacked.

In some possible implementations, the atomic layer deposition process may be used to form the first ferroelectric thin film 211, the first doping thin film 301, the second ferroelectric thin film 221, and the second doping thin film 302. Each first ferroelectric thin film 211, each second ferroelectric thin film 221, each first doping thin film 301, and each second doping thin film 302 are separate thin films respectively, the first ferroelectric thin film 211 does not include the material of the first doping thin film 301, and the second ferroelectric thin film 221 does not include a material of the second doping thin film 302.

In some possible implementations, when a total thickness of the first ferroelectric function layer 21 is the same as a total thickness of the second ferroelectric function layer 22, a doping concentration of one first doping thin film 301 in the first ferroelectric function layer 21 may be the same as a doping concentration of one second doping thin film 302 in the second ferroelectric function layer 22. A quantity of second doping thin films 302 is enabled to be greater than a quantity of first doping thin films 301, so that a total doping concentration of all the second doping thin films 302 is greater than a total doping concentration of all the first doping thin films 301. Certainly, the thickness of the first ferroelectric function layer 21 may be different from the thickness of the second ferroelectric function layer 22, provided that the doping concentration of the doping layer 30 in the first ferroelectric function layer 21 is less than the doping concentration of the doping layer 30 in the second ferroelectric function layer 22.

An example in which a total thickness of the ferroelectric function layer 20 is 10 nm, and the thicknesses of the first ferroelectric function layer 21 and the second ferroelectric function layer 22 are the same is used. A thickness range of the first ferroelectric thin film 211 may be 3 nm to 4 nm. For example, a thickness of the first ferroelectric thin film 211 is 3 nm, 3.4 nm, or 4 nm. A thickness range of the second ferroelectric thin film 221 may be 0.8 nm to 1.2 nm. For example, a thickness of the second ferroelectric thin film 221 is 0.8 nm, 1 nm, or 1.2 nm. Thickness ranges of the first doping thin film 301 and the second doping thin film 302 may be 0.08 nm to 0.12 nm. For example, thicknesses of the first doping thin film 301 and the second doping thin film 302 are 0.08 nm, 0.1 nm, or 0.12 nm.

Certainly, the total thickness of the ferroelectric function layer 20 may be another value. Optionally, the total thickness of the ferroelectric function layer 20 may be 2 nm to 30 nm. For example, the total thickness of the ferroelectric function layer 20 is 2 nm, 4 nm, 12 nm, 20 nm, 26 nm, or 30 nm. In this case, quantities of first ferroelectric thin films 211, second ferroelectric thin films 221, first doping thin films 301, and second doping thin films 302 may remain unchanged, but thicknesses decrease or increase with the total thickness of the ferroelectric function layer 20.

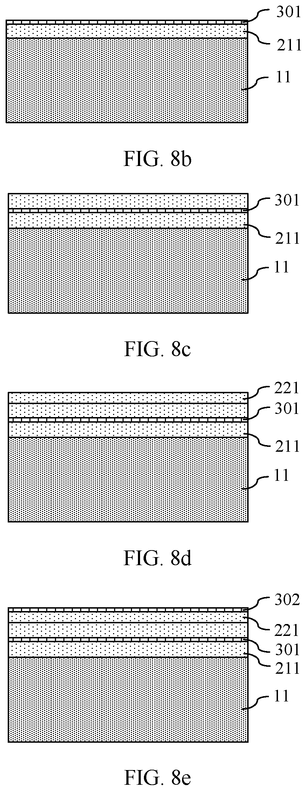

The following uses an example in which the first ferroelectric function layer 21 and the second ferroelectric function layer 22 each include the doping layer 30, to describe a production process of the first ferroelectric function layer 21 and the second ferroelectric function layer 22. As shown in FIG. 8a, the first ferroelectric thin film 211 is formed on the first electrode 11. As shown in FIG. 8b, the first ferroelectric thin film 301 is formed on a side that is of the first ferroelectric thin film 211 and that faces away from the first electrode 11. As shown in FIG. 8c, the first ferroelectric thin film 211 is formed again on a side that is of the first doping thin film 301 and that faces away from the first electrode 11, to obtain the first ferroelectric function layer 21. Then, as shown in FIG. 8d, the second ferroelectric thin film 221 is formed on a side that is of the first ferroelectric function layer 21 and that faces away from the first electrode 11. As shown in FIG. 8e, the second doping thin film 302 is formed on a side that is of the second ferroelectric thin film 221 and that faces away from the first electrode 11. As shown in FIG. 8f, the second ferroelectric thin film 221 is formed again on a side that is of the second doping thin film 302 and that faces away from the first electrode 11. As shown in FIG. 8g, the foregoing steps of forming the second doping thin film 302 and the second ferroelectric thin film 221 are repeated in sequence until the second ferroelectric function layer 22 is formed.

Certainly, the foregoing production process is described by using an example in which the first ferroelectric function layer 21 and the second ferroelectric function layer 22 are sequentially formed on the first electrode 11. In embodiments of this application, the second ferroelectric function layer 22 and the first ferroelectric function layer 21 may alternatively be sequentially formed on the second electrode 12. In addition, if the second ferroelectric function layer 22 includes the doping layer 30, and the first ferroelectric function layer 21 does not include the doping layer 30, the first ferroelectric thin film 211 may alternatively be first formed, to obtain the first ferroelectric function layer 21, and then the second ferroelectric function layer 22 is formed by using steps corresponding to FIG. 8d to FIG. 8g.

In addition, the foregoing production process is described by using an example in which the first ferroelectric function layer 21 includes one first doping thin film 301, and the second ferroelectric function layer 22 includes a plurality of second doping thin films 302. Alternatively, there may be another quantity of first doping thin films 301 and another quantity of second doping thin films 302. This is not limited in embodiments of this application. A relationship between a quantity of first doping thin films 301 and a quantity of second doping thin films 302 is related to electric field strength of the first internal electric field formed by the first electrode 11 and the second electrode 12, and doping concentrations of each first doping thin film 301 and each second doping thin film 302. In embodiments of this application, the quantity of first doping thin films 301 and the quantity of second doping thin films 302 may be adjusted based on an actual situation.

The foregoing embodiment is described by using an example in which the work function WF1 of the first electrode 11 is less than the work function WF2 of the second electrode 12. In some other possible implementations, if the work function WF1 of the first electrode 11 is greater than the work function WF2 of the second electrode 12, when the electronegativity of the doping layer 30 is greater than the electronegativity of the ferroelectric oxide layer, the doping concentration of the doping layer 30 in the first ferroelectric function layer 21 may be greater than the doping concentration of the doping layer 30 in the second ferroelectric function layer 22.

In some possible implementations, in actual application, as shown in FIG. 4a and FIG. 4b, the MFM structure in embodiments of this application may be used as a two-dimensional capacitor structure, the first electrode 11 of the MFM structure may be a first pole of the two-dimensional capacitor structure, and the second electrode 12 may be a second pole of the two-dimensional capacitor structure.

Alternatively, as shown in FIG. 7a, the MFM structure in embodiments of this application may be used for a ferroelectric random access memory of a three-dimensional structure, the ferroelectric random access memory includes a plurality of capacitors and a plurality of plate lines (plate lines, PLs), the capacitor includes a first pole and a second pole, first poles of the plurality of capacitors are respectively coupled to different plate lines (for example, PL1,1 and PL1,2), and second poles of the plurality of capacitors are coupled to each other. As shown in FIG. 7b to FIG. 7e, the MFM structure may include a plurality of capacitors and a plurality of plate lines that are respectively coupled to the plurality of capacitors. Specifically, the MFM structure includes a plurality of first electrodes 11 and one second electrode 12. Each first electrode 11 is reused as a first pole of one plate line and one capacitor in the ferroelectric random access memory. The second electrode 12 may be used as second poles of the plurality of capacitors, and the second poles of the plurality of capacitors are coupled to each other. The first ferroelectric function layer 21 and the second ferroelectric function layer 22 may be disposed between the plurality of plate lines and a second pole of one capacitor. When the MFM structure is used for the ferroelectric random access memory, for a specific structure and material of MFM, refer to the foregoing embodiment. Details are not described herein again.

In still another embodiment, as shown in FIG. 9, if the work function WF1 of the first electrode 11 is less than the work function WF2 of the second electrode 12, a first internal electric field from the first electrode 11 to the second electrode 12 exists in the MFM structure, and a magnitude of the first internal electric field is directly proportional to a difference between the work functions of the first electrode 11 and the second electrode 12. The first internal electric field acts on the entire ferroelectric function layer 20, which is equivalent to that when no external electric field is applied, the ferroelectric function layer 20 already bears an electric field with a fixed direction and magnitude. This causes electrical asymmetry of the MFM structure. For example, as shown in FIG. 5a, in the first internal electric field, an electric potential difference between the first electrode 11 and the second electrode 12 is ϕ1. Based on this, the first ferroelectric function layer 21 may further include a first doping layer 31 other than the ferroelectric oxide layer, and the second ferroelectric function layer 22 may further include a second doping layer 32 other than the ferroelectric oxide layer. In addition, electronegativity of the first doping layer 31 may be less than the electronegativity of the ferroelectric oxide layer, and electronegativity of the second doping layer 32 may be greater than the electronegativity of the ferroelectric oxide layer.

It should be noted herein that, a doping concentration of the first doping layer 31 in the first ferroelectric function layer 21 may be the same as or different from a doping concentration of the second doping layer 32 in the second ferroelectric function layer 22. A concentration relationship between the two depends on a relationship between the electronegativity of the first doping layer 31 and the second doping layer 32 and the electronegativity of the ferroelectric oxide layer, and a work function relationship between the first electrode 11 and the second electrode 12.

A person skilled in the art should know that larger electronegativity indicates a stronger capability of electron absorption, and smaller electronegativity indicates a weaker capability of electron absorption. In addition, an electron is negative. Because the electronegativity of the first doping layer 31 is less than the electronegativity of the ferroelectric oxide layer, and the electronegativity of the second doping layer 32 is greater than the electronegativity of the ferroelectric oxide layer, a capability of electron absorption of the second ferroelectric function layer 22 is greater than a capability of electron absorption of the first ferroelectric function layer 21. As shown in FIG. 5b, an electric dipole and a second internal electric field may be generated on a contact surface between the first ferroelectric function layer 21 and the second ferroelectric function layer 22. Because the second ferroelectric function layer 22 has the stronger capability of electron absorption, and a direction of the electric dipole is from the first ferroelectric function layer 21 to the second ferroelectric function layer 22, a direction of the second internal electric field may be a direction from the first ferroelectric function layer 21 to the second ferroelectric function layer 22. Although the second internal electric field and the first internal electric field have a same direction, on one hand, the second internal electric field mainly locally exists on the interface between the first ferroelectric function layer 21 and the second ferroelectric function layer 22, but does not act on the entire ferroelectric function layer 20, and therefore does not cause the asymmetry of the entire MFM structure operated in the external electric field. On the other hand, because a sum of the first internal electric field and the second internal electric field is directly proportional to the difference between the work functions of the first electrode 11 and the second electrode 12, the existence of the second internal electric field reduces the first internal electric field, and reduces the electrical asymmetry of the MFM structure caused by the first internal electric field.

In this way, as shown in FIG. 5a and FIG. 5b, the second internal electric field is adjusted by adjusting the doping concentration of the first doping layer 31 and/or the doping concentration of the second doping layer 32. For example, in the second internal electric field, an electric potential difference between the first ferroelectric function layer 21 and the second ferroelectric function layer 22 is ϕ2. The second internal electric field is used to neutralize the first internal electric field, so that an electric potential difference of the first internal electric field is reduced to ϕ3, where ϕ3 = ϕ1 - ϕ2. In this way, the problem of the electrical asymmetry caused by the asymmetric work functions of the first electrode 11 and the second electrode 12 is resolved, symmetry of the MFM structure is improved, and the electrical performance of the MFM structure is accurately controlled. The problems of the positive-negative erase and write asymmetry, the incomplete reversal in a direction, and the anti-interference asymmetry that occur when the MFM structure is used for the ferroelectric random access memory are avoided.

In some possible implementations, the doping concentration of the first doping layer 31 in the first ferroelectric function layer 21 and the doping concentration of the second doping layer 32 in the second ferroelectric function layer 22 are not limited in embodiments of this application, and the doping concentration of the first doping layer 31 and the doping concentration of the second doping layer 32 are related to the difference between the work functions of the first electrode 11 and the second electrode 12 and a degree of adjustment that a person skilled in the art wants to perform on asymmetry of the MFM structure. Optionally, in this embodiment, the doping concentration of the first doping layer 31 may be (0 mol%, 25 mol%], and the doping concentration of the second doping layer 32 may be (0 mol%, 25 mol%].

For example, a material of the first electrode 11 may include tungsten produced by using a physical vapor deposition method, a material of the second electrode 12 may include titanium nitride produced by using an atomic layer deposition method, a total thickness of the ferroelectric function layer 20 is 10 nm, and a thickness of the first ferroelectric function layer 21 and a thickness of the second ferroelectric function layer 22 are both 5 nm. A material of the ferroelectric oxide layer may include hafnium zirconium oxide, a material of the first doping layer 31 may include lanthanum oxide, and a material of the second doping layer 32 may include aluminum oxide. A work function WF1 of tungsten is 4.55 eV, a work function WF2 of titanium nitride is 5.27 eV, and a direction of the first internal electric field is from the first electrode 11 to the second electrode 12. In addition, because electronegativity of lanthanum is less than electronegativity of hafnium and zirconium, and electronegativity of aluminum is greater than the electronegativity of hafnium and zirconium, a total concentration of lanthanum oxide in the first ferroelectric function layer 21, that is, hafnium zirconium oxide on a tungsten side, may be 2.4 mol%, and a total concentration of aluminum oxide in the second ferroelectric function layer 22, that is, hafnium zirconium oxide on a titanium nitride side, may be 2.4 mol%, to form the second internal electric field with a direction from the first ferroelectric function layer 21 to the second ferroelectric function layer 22, and resolve an electrical asymmetry problem caused by the different work functions of tungsten and titanium nitride.

Certainly, due to existence of the first ferroelectric function layer 21 and the second ferroelectric function layer 22, the electrical asymmetry of the MFM structure may be adjusted by adjusting the doping concentration of the first doping layer 31 in the first ferroelectric function layer 21 and the doping concentration of the second doping layer 32 in the second ferroelectric function layer 22. Therefore, specific materials of the first electrode 11 and the second electrode 12 are not limited in embodiments of this application. Descriptions of the materials of the first electrode 11 and the second electrode 12 are the same as the descriptions of the materials of the first electrode 11 and the second electrode 12 in the foregoing embodiment, and details are not described herein again.

Similarly, specific materials of the ferroelectric oxide layer, the first doping layer 31, and the second doping layer 32 are not limited in embodiments of this application, provided that the electronegativity of the first doping layer 31 is less than the electronegativity of the ferroelectric oxide layer, and the electronegativity of the second doping layer 32 is greater than the electronegativity of the ferroelectric oxide layer.

For example, the ferroelectric oxide layer includes hafnium zirconium oxide, and the first doping layer 31 includes at least one of lanthanum oxide, yttrium oxide, cerium oxide, strontium oxide, and gadolinium oxide. Alternatively, the ferroelectric oxide layer includes hafnium dioxide, and the first doping layer 31 includes at least one of silicon dioxide, aluminum oxide, lanthanum oxide, yttrium oxide, gadolinium oxide, and strontium oxide.

The ferroelectric oxide layer includes hafnium zirconium oxide, and the second doping layer 32 includes at least one of aluminum oxide, silicon dioxide, gallium oxide, and germanium oxide.

Because hafnium and zirconium are quadrivalent, there are many oxygen vacancy defects in the ferroelectric oxide layer. In this application, oxygen vacancy defect concentrations in the first ferroelectric function layer 21 and the second ferroelectric function layer 22 may be reduced by enabling the first ferroelectric function layer 21 to include the first doping layer 31, the second ferroelectric function layer 22 to include the second doping layer 32, and the first doping layer 31 (for example, lanthanum oxide) and the second doping layer 32 (for example, aluminum oxide) to include a trivalent doping material. When the MFM structure is used for the ferroelectric random access memory, the ferroelectric tunneling junction, or a ferroelectric field effect transistor, reliability parameters such as leakage, cycle life, and a retention characteristic of the ferroelectric random access memory, the ferroelectric tunneling junction, or the ferroelectric field effect transistor can be improved.

In addition, an atomic layer deposition process may be used to form the first doping layer 31 and the second doping layer 32. The ferroelectric oxide layer in the first ferroelectric function layer 21 includes at least one first ferroelectric thin film 211, the ferroelectric oxide layer in the second ferroelectric function layer 22 includes at least one second ferroelectric thin film 221, the first doping layer 31 may include at least one first doping thin film 301, and the second doping layer 32 may include at least one second doping thin film 302. A specific production process, an existence form of the first doping layer 31 in the first ferroelectric function layer 21, and an existence form of the second doping layer 32 in the second ferroelectric function layer 22 are the same as the production process described in the foregoing embodiment, an existence form of the first doping thin film 211 in the first ferroelectric function layer 21, and an existence form of the second doping thin film 302 in the second ferroelectric function layer 22. Details are not described herein again.

The foregoing embodiment is described by using an example in which the work function WF1 of the first electrode 11 is less than the work function WF2 of the second electrode 12. In some other possible implementations, if the work function WF1 of the first electrode 11 is greater than the work function WF2 of the second electrode 12, the electronegativity of the first doping layer 31 may be greater than the electronegativity of the ferroelectric oxide layer, and the electronegativity of the second doping layer 32 may be less than the electronegativity of the ferroelectric oxide layer.

In some possible implementations, in actual application, as shown in FIG. 9, the MFM structure in embodiments of this application may be used as a two-dimensional capacitor structure, the first electrode 11 of the MFM structure may be a first pole of the two-dimensional capacitor structure, and the second electrode 12 may be a second pole of the two-dimensional capacitor structure.

Alternatively, as shown in FIG. 7a, the MFM structure in embodiments of this application may be used for a ferroelectric random access memory of a three-dimensional structure, the ferroelectric random access memory includes a plurality of capacitors and a plurality of plate lines (plate lines, PLs), the capacitor includes a first pole and a second pole, first poles of the plurality of capacitors are respectively coupled to different plate lines (for example, PL1,1 and PL1,2), and second poles of the plurality of capacitors are coupled to each other. Refer to FIG. 7b to FIG. 7e. The MFM structure may include a plurality of capacitors and a plurality of plate lines that are respectively coupled to the plurality of capacitors. Specifically, the MFM structure includes a plurality of first electrodes 11 and one second electrode 12. Each first electrode 11 is reused as a first pole of one plate line and one capacitor in the ferroelectric random access memory. The second electrode 12 may be used as second poles of the plurality of capacitors, and the second poles of the plurality of capacitors are coupled to each other. The first ferroelectric function layer 21 and the second ferroelectric function layer 22 may be disposed between the plurality of plate lines and a second pole of one capacitor. When the MFM structure is used for the ferroelectric random access memory, for a specific structure and material of MFM, refer to the foregoing embodiment. Details are not described herein again.

According to the descriptions of the foregoing embodiment, the different work functions of the first electrode 11 and the second electrode 12 cause the electrical asymmetry of the MFM structure, and the doping concentrations of the doping layers 30 in the first ferroelectric function layer 21 and the second ferroelectric function layer 22 are adjusted, to improve electrical symmetry of the MFM structure.

In some other embodiments, when the work function of the first electrode 11 is different from the work function of the second electrode 12, or the work function of the first electrode 11 is the same as the work function of the second electrode 12, the electric potential difference between the first electrode 11 and the second electrode 12 in the MFM structure may be further increased by adjusting the doping concentrations of the doping layers 30 in the first ferroelectric function layer 21 and the second ferroelectric function layer 22. When the MFM structure is used for a ferroelectric tunneling junction, an on/off ratio between the first electrode 11 and the second electrode 12 may be adjusted when a voltage difference applied to the first electrode 11 and the second electrode 12 remains unchanged. For ease of description, the following provides descriptions by using an example in which the work function of the first electrode 11 is the same as the work function of the second electrode 12. The following describes a specific structure of the MFM structure with reference to the accompanying drawings.

As shown in FIG. 3a to FIG. 4b, along a direction from the first electrode 11 to the second electrode 12, the ferroelectric function layer 20 includes the first ferroelectric function layer 21 and the second ferroelectric function layer 22 that are alternately stacked. The first ferroelectric function layer 21 and the second ferroelectric function layer 22 each include a ferroelectric oxide layer, and the first ferroelectric function layer 21 and/or the second ferroelectric function layer 22 further include/includes a doping layer 30. Electronegativity of the doping layer 30 is different from electronegativity of the ferroelectric oxide layer, and a doping concentration of the doping layer 30 in the first ferroelectric function layer 21 is different from a doping concentration of the doping layer 30 in the second ferroelectric function layer 22.

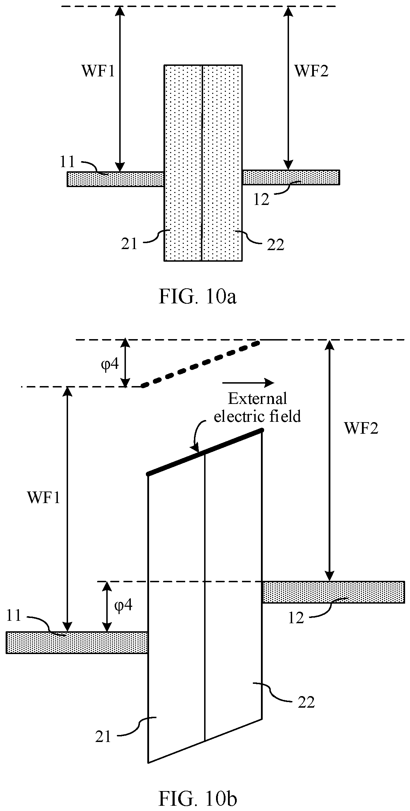

In an embodiment, as shown in FIG. 10a, if the work function WF1 of the first electrode 11 is equal to the work function WF2 of the second electrode 12, an electric potential difference between the first electrode 11 and the second electrode 12 is 0, and no first internal electric field exists between the first electrode 11 and the second electrode 12.

As shown in FIG. 10b, in a working state, a first voltage may be applied to the first electrode 11, and a second voltage may be applied to the second electrode 12, where the first voltage is greater than the second voltage. An external electric field is formed between the first electrode 11 and the second electrode 12, the electric potential difference between the first electrode 11 and the second electrode 12 is ϕ4, and a direction of the external electric field may be from the first electrode 11 to the second electrode 12.

As shown in FIG. 3a and FIG. 3b, when the first voltage and the second voltage are not changed, to adjust the on/off ratio between the first electrode 11 and the second electrode 12, the first ferroelectric function layer 21 and/or the second ferroelectric function layer 22 may further include the doping layer 30 other than the ferroelectric oxide layer. In this embodiment of this application, the electronegativity of the doping layer 30 may be less than the electronegativity of the ferroelectric oxide layer, and the doping concentration of the doping layer 30 in the first ferroelectric function layer 21 is greater than the doping concentration of the doping layer 30 in the second ferroelectric function layer 22.

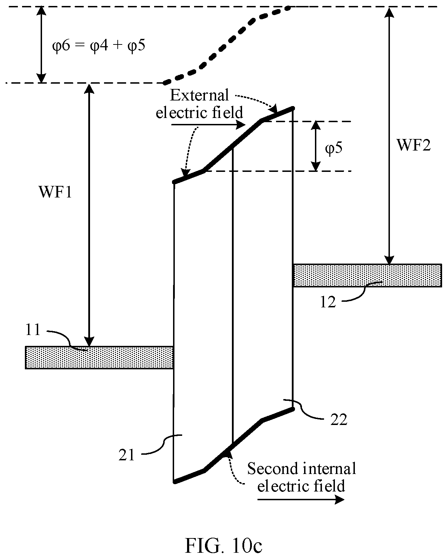

Because the concentration of the doping layer 30 in the first ferroelectric function layer 21 is greater than the concentration of the doping layer 30 in the second ferroelectric function layer 22, and the electronegativity of the doping layer 30 is less than the electronegativity of the ferroelectric oxide layer, a capability of electron absorption of the second ferroelectric function layer 22 is greater than a capability of electron absorption of the first ferroelectric function layer 21. As shown in FIG. 10c, an electric dipole and a second internal electric field may be generated on a contact surface between the first ferroelectric function layer 21 and the second ferroelectric function layer 22. Because the second ferroelectric function layer 22 has the stronger capability of electron absorption, and a direction of the electric dipole is from the first ferroelectric function layer 21 to the second ferroelectric function layer 22, a direction of the second internal electric field may be a direction from the first ferroelectric function layer 21 to the second ferroelectric function layer 22, and an electric potential difference generated between the first electrode 11 and the second electrode 12 due to the second internal electric field is ϕ5. The external electric field is accumulated with the second internal electric field, so that the electric potential difference between the first electrode 11 and the second electrode 12 reaches ϕ6, where ϕ6 = ϕ4 + ϕ5, and ϕ4 and ϕ5 are both positive values. In this way, if the external electric field is constant, an electric field actually experienced by the ferroelectric function layer 20 may be increased, and this helps adjust the on/off ratio. In addition, the second internal electric field mainly locally exists on the interface between the first ferroelectric function layer 21 and the second ferroelectric function layer 22, but does not act on the entire ferroelectric function layer 20, and therefore does not cause the asymmetry of the entire MFM structure operated in the external electric field.

In some possible implementations, the doping concentration of the doping layer 30 in the first ferroelectric function layer 21 and the doping concentration of the doping layer 30 in the second ferroelectric function layer 22 are not limited in embodiments of this application, and the doping concentration of the doping layer 30 in the first ferroelectric function layer 21 and the doping concentration of the doping layer 30 in the second ferroelectric function layer 22 are related to a degree of adjustment that a person skilled in the art wants to perform on the on/off ratio of the MFM structure. Optionally, in this embodiment, the doping concentration of the doping layer 30 in the first ferroelectric function layer 21 may be (0 mol%, 25 mol%], the doping concentration of the doping layer 30 in the second ferroelectric function layer 22 may be [0 mol%, 25 mol%), and the doping concentration of the doping layer 30 in the first ferroelectric function layer 21 is greater than the doping concentration of the doping layer 30 in the second ferroelectric function layer 22.

In addition, other explanations and beneficial effects of that the first ferroelectric function layer 21 and/or the second ferroelectric function layer 22 include/includes the doping layer 30 and the electronegativity of the doping layer 30 is less than the electronegativity of the ferroelectric oxide layer are the same as explanations and beneficial effects of the foregoing embodiment in which the first ferroelectric function layer 21 and/or the second ferroelectric function layer 22 include/includes the doping layer 30 and the electronegativity of the doping layer 30 is less than the electronegativity of the ferroelectric oxide layer in the foregoing. Details are not described herein again.

The foregoing embodiment provides a doping status of the first ferroelectric function layer 21 and the second ferroelectric function layer 22 in a case in which the work function WF1 of the first electrode 11 is the same as the work function WF2 of the second electrode 12. In some other possible implementations, the work function WF1 of the first electrode 11 may be different from the work function WF2 of the second electrode 12.

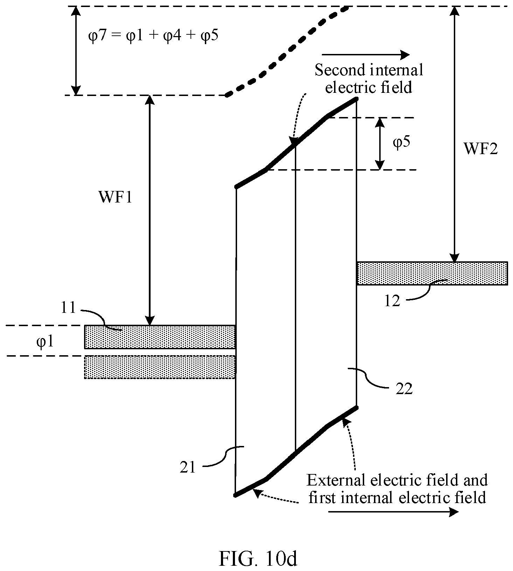

For example, as shown in FIG. 10d, the work function WF1 of the first electrode 11 is less than the work function WF2 of the second electrode 12, and the MFM structure further has the first internal electric field with a direction from the first electrode 11 to the second electrode 12. In the first internal electric field, the electric potential difference between the first electrode 11 and the second electrode 12 is ϕ1. In this way, the external electric field is accumulated with the first internal electric field and the second internal electric field, so that the electric potential difference between the first electrode 11 and the second electrode 12 reaches ϕ7, where ϕ7 = ϕ1 + ϕ4 + ϕ5, and ϕ1, ϕ4, and ϕ5 are all positive values. In this way, the on/off ratio may be adjusted in the constant external electric field.

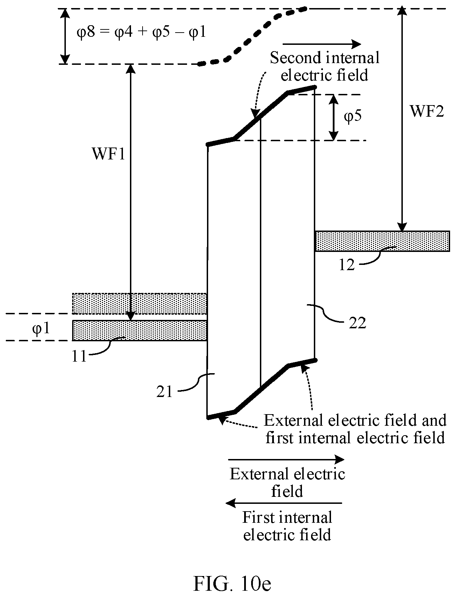

For another example, as shown in FIG. 10e, the work function WF1 of the first electrode 11 is greater than the work function WF2 of the second electrode 12, and the MFM structure further has the first internal electric field with a direction from the second electrode 12 to the first electrode 11. For example, in the first internal electric field, the electric potential difference between the second electrode 12 and the first electrode 11 is ϕ1. In this way, the external electric field is accumulated with the first internal electric field and the second internal electric field, so that the electric potential difference between the first electrode 11 and the second electrode 12 reaches ϕ8, where ϕ8 = ϕ4 + ϕ5 - ϕ1, and ϕ1, ϕ4, and ϕ5 are all positive values. In this way, in the constant external electric field, the on/off ratio may be adjusted based on the work function WF1 of the first electrode 11 and the work function WF2 of the second electrode 12.

In addition, in some application scenarios, the direction of the external electric field may be opposite to the direction of the second internal electric field. This is not limited in embodiments of this application.

In another embodiment, as shown in FIG. 10a, if the work function WF1 of the first electrode 11 is equal to the work function WF2 of the second electrode 12, an electric potential difference between the first electrode 11 and the second electrode 12 is 0, and no first internal electric field exists between the first electrode 11 and the second electrode 12.

As shown in FIG. 10b, in a working state, a first voltage may be applied to the first electrode 11, and a second voltage may be applied to the second electrode 12, where the first voltage is greater than the second voltage. An external electric field is formed between the first electrode 11 and the second electrode 12, the electric potential difference between the first electrode 11 and the second electrode 12 is ϕ4, and a direction of the external electric field is from the first electrode 11 to the second electrode 12.

As shown in FIG. 4a and FIG. 4b, when the first voltage and the second voltage are not changed, to adjust the on/off ratio between the first electrode 11 and the second electrode 12, the first ferroelectric function layer 21 and/or the second ferroelectric function layer 22 may further include the doping layer 30 other than the ferroelectric oxide layer. In addition, in this embodiment of this application, the electronegativity of the doping layer 30 may be greater than the electronegativity of the ferroelectric oxide layer, and the doping concentration of the doping layer 30 in the first ferroelectric function layer 21 is less than the doping concentration of the doping layer 30 in the second ferroelectric function layer 22.

Because the concentration of the doping layer 30 in the first ferroelectric function layer 21 is less than the concentration of the doping layer 30 in the second ferroelectric function layer 22, and the electronegativity of the doping layer 30 is greater than the electronegativity of the ferroelectric oxide layer, a capability of electron absorption of the second ferroelectric function layer 22 is greater than a capability of electron absorption of the first ferroelectric function layer 21. As shown in FIG. 10c, an electric dipole and a second internal electric field may be generated on a contact surface between the first ferroelectric function layer 21 and the second ferroelectric function layer 22. Because the second ferroelectric function layer 22 has the stronger capability of electron absorption, and a direction of the electric dipole is from the first ferroelectric function layer 21 to the second ferroelectric function layer 22, a direction of the second internal electric field may be a direction from the first ferroelectric function layer 21 to the second ferroelectric function layer 22, and an electric potential difference generated between the second electrode 12 and the first electrode 11 due to the second internal electric field is ϕ5. The external electric field is accumulated with the second internal electric field, so that the electric potential difference between the first electrode 11 and the second electrode 12 reaches ϕ6, where ϕ6 = ϕ4 + ϕ5, and ϕ4 and ϕ5 are both positive values. In this way, if the external electric field is constant, an electric field actually experienced by the ferroelectric function layer 20 may be increased, and this helps adjust the on/off ratio. In addition, the second internal electric field mainly locally exists on the interface between the first ferroelectric function layer 21 and the second ferroelectric function layer 22, but does not act on the entire ferroelectric function layer 20, and therefore does not cause the asymmetry of the entire MFM structure operated in the external electric field.

In some possible implementations, the doping concentration of the doping layer 30 in the first ferroelectric function layer 21 and the doping concentration of the doping layer 30 in the second ferroelectric function layer 22 are not limited in embodiments of this application, and the doping concentration of the doping layer 30 in the first ferroelectric function layer 21 and the doping concentration of the doping layer 30 in the second ferroelectric function layer 22 are related to a degree of adjustment that a person skilled in the art wants to perform on the on/off ratio of the MFM structure. Optionally, in this embodiment, the doping concentration of the doping layer 30 in the first ferroelectric function layer 21 may be [0 mol%, 25 mol%), the doping concentration of the doping layer 30 in the second ferroelectric function layer 22 may be (0 mol%, 25 mol%], and the doping concentration of the doping layer 30 in the first ferroelectric function layer 21 is less than the doping concentration of the doping layer 30 in the second ferroelectric function layer 22.

In addition, other explanations and beneficial effects of that the first ferroelectric function layer 21 and/or the second ferroelectric function layer 22 include/includes the doping layer 30 and the electronegativity of the doping layer 30 is greater than the electronegativity of the ferroelectric oxide layer are the same as explanations and beneficial effects of the foregoing embodiment in which the first ferroelectric function layer 21 and/or the second ferroelectric function layer 22 include/includes the doping layer 30 and the electronegativity of the doping layer 30 is greater than the electronegativity of the ferroelectric oxide layer in the foregoing. Details are not described herein again.

The foregoing embodiment provides a doping status of the first ferroelectric function layer 21 and the second ferroelectric function layer 22 in a case in which the work function WF1 of the first electrode 11 is the same as the work function WF2 of the second electrode 12. In some other possible implementations, the work function WF1 of the first electrode 11 may be different from the work function WF2 of the second electrode 12.

For example, as shown in FIG. 10d, the work function WF1 of the first electrode 11 is less than the work function WF2 of the second electrode 12, and the MFM structure further has the first internal electric field with a direction from the first electrode 11 to the second electrode 12. In the first internal electric field, the electric potential difference between the first electrode 11 and the second electrode 12 is ϕ1. In this way, the external electric field is accumulated with the first internal electric field and the second internal electric field, so that the electric potential difference between the first electrode 11 and the second electrode 12 reaches ϕ7, where ϕ7 = ϕ1 + ϕ4 + ϕ5, and ϕ1, ϕ4, and ϕ5 are all positive values. In this way, the on/off ratio may be adjusted in the constant external electric field.

For another example, as shown in FIG. 10e, the work function WF1 of the first electrode 11 is greater than the work function WF2 of the second electrode 12, and the MFM structure further has the first internal electric field with a direction from the second electrode 12 to the first electrode 11. For example, in the first internal electric field, the electric potential difference between the second electrode 12 and the first electrode 11 is ϕ1. In this way, the external electric field is accumulated with the first internal electric field and the second internal electric field, so that the electric potential difference between the first electrode 11 and the second electrode 12 reaches ϕ8, where ϕ8 = ϕ4 + ϕ5 - ϕ1, and ϕ1, ϕ4, and ϕ5 are all positive values. In this way, in the constant external electric field, the on/off ratio may be adjusted based on the work function WF1 of the first electrode 11 and the work function WF2 of the second electrode 12.

In addition, in some application scenarios, the direction of the external electric field may be opposite to the direction of the second internal electric field. This is not limited in embodiments of this application.

In still another embodiment, as shown in FIG. 10a, if the work function WF1 of the first electrode 11 is equal to the work function WF2 of the second electrode 12, an electric potential difference between the first electrode 11 and the second electrode 12 is 0, and no first internal electric field exists between the first electrode 11 and the second electrode 12.

As shown in FIG. 10b, in a working state, a first voltage may be applied to the first electrode 11, and a second voltage may be applied to the second electrode 12, where the first voltage is greater than the second voltage. An external electric field is formed between the first electrode 11 and the second electrode 12, the electric potential difference between the first electrode 11 and the second electrode 12 is ϕ4, and a direction of the external electric field is from the first electrode 11 to the second electrode 12.

As shown in FIG. 9, when the first voltage and the second voltage are not changed, to adjust the on/off ratio between the first electrode 11 and the second electrode 12, the first ferroelectric function layer 21 may further include the first doping layer 31 other than the ferroelectric oxide layer, and the second ferroelectric function layer 22 may further include the second doping layer 32 other than the ferroelectric oxide layer. The electronegativity of the first doping layer 31 is less than the electronegativity of the ferroelectric oxide layer, and the electronegativity of the second doping layer 32 is greater than the electronegativity of the ferroelectric oxide layer.

Because the electronegativity of the first doping layer 31 is less than the electronegativity of the ferroelectric oxide layer, and the electronegativity of the second doping layer 32 is greater than the electronegativity of the ferroelectric oxide layer, a capability of electron absorption of the second ferroelectric function layer 22 is greater than a capability of electron absorption of the first ferroelectric function layer 21. As shown in FIG. 10c, an electric dipole and a second internal electric field may be generated on a contact surface between the first ferroelectric function layer 21 and the second ferroelectric function layer 22. Because the second ferroelectric function layer 22 has the stronger capability of electron absorption, and a direction of the electric dipole is from the first ferroelectric function layer 21 to the second ferroelectric function layer 22, a direction of the second internal electric field may be a direction from the first ferroelectric function layer 21 to the second ferroelectric function layer 22, and an electric potential difference generated between the second electrode 12 and the first electrode 11 due to the second internal electric field is ϕ5. The external electric field is accumulated with the second internal electric field, so that the electric potential difference between the first electrode 11 and the second electrode 12 reaches ϕ6, where ϕ6 = ϕ4 + ϕ5, and ϕ4 and ϕ5 are both positive values. In this way, if the external electric field is constant, an electric field actually experienced by the ferroelectric function layer 20 may be increased, and this helps adjust the on/off ratio. In addition, the second internal electric field mainly locally exists on the interface between the first ferroelectric function layer 21 and the second ferroelectric function layer 22, but does not act on the entire ferroelectric function layer 20, and therefore does not cause the asymmetry of the entire MFM structure operated in the external electric field.

In some possible implementations, the doping concentration of the first doping layer 31 in the first ferroelectric function layer 21 and the doping concentration of the second doping layer 32 in the second ferroelectric function layer 22 are not limited in embodiments of this application, and the doping concentration of the first doping layer 31 and the doping concentration of the second doping layer 32 are related to the first electrode 11 and a degree of adjustment that a person skilled in the art wants to perform on the on/off ratio of the MFM structure. Optionally, in this embodiment, the doping concentration of the first doping layer 31 may be (0 mol%, 25 mol%], and the doping concentration of the second doping layer 32 may be (0 mol%, 25 mol%].

In addition, other explanations and beneficial effects of that the first ferroelectric function layer 21 includes the first doping layer 31 and the second ferroelectric function layer 22 includes the second doping layer 32 are the same as explanations and beneficial effects of the foregoing embodiment in which the first ferroelectric function layer 21 includes the first doping layer 31 and the second ferroelectric function layer 22 includes the second doping layer 32. Details are not described herein again.

The foregoing embodiment provides a doping status of the first ferroelectric function layer 21 and the second ferroelectric function layer 22 in a case in which the work function WF1 of the first electrode 11 is the same as the work function WF2 of the second electrode 12. In some other possible implementations, the work function WF 1 of the first electrode 11 may be different from the work function WF2 of the second electrode 12.

For example, as shown in FIG. 10d, the work function WF1 of the first electrode 11 is less than the work function WF2 of the second electrode 12, and the MFM structure further has the first internal electric field with a direction from the first electrode 11 to the second electrode 12. In the first internal electric field, the electric potential difference between the first electrode 11 and the second electrode 12 is ϕ1. In this way, the external electric field is accumulated with the first internal electric field and the second internal electric field, so that the electric potential difference between the first electrode 11 and the second electrode 12 reaches ϕ7, where ϕ7 = ϕ1 + ϕ4 + ϕ5, and ϕ1, ϕ4, and ϕ5 are all positive values. In this way, the on/off ratio may be adjusted in the constant external electric field.

For another example, as shown in FIG. 10e, the work function WF1 of the first electrode 11 is greater than the work function WF2 of the second electrode 12, and the MFM structure further has the first internal electric field with a direction from the second electrode 12 to the first electrode 11. For example, in the first internal electric field, the electric potential difference between the second electrode 12 and the first electrode 11 is ϕ1. In this way, the external electric field is accumulated with the first internal electric field and the second internal electric field, so that the electric potential difference between the first electrode 11 and the second electrode 12 reaches ϕ8, where ϕ8 = ϕ4 + ϕ5 - ϕ1, and ϕ1, ϕ4, and ϕ5 are all positive values. In this way, in the constant external electric field, the on/off ratio may be adjusted based on the work function WF1 of the first electrode 11 and the work function WF2 of the second electrode 12.

In addition, in some application scenarios, the direction of the external electric field may be opposite to the direction of the second internal electric field. This is not limited in embodiments of this application.

The foregoing describes embodiments of this application with reference to the accompanying drawings. However, this application is not limited to the foregoing specific implementations. The foregoing specific implementations are merely examples, but are not limitative. Inspired by this application, a person of ordinary skill in the art may further make modifications without departing from the purposes of this application and the protection scope of the claims, and all the modifications shall fall within the protection of this application.

## Claims

1. A chip, comprising a first electrode, a first ferroelectric function layer, a second ferroelectric function layer, and a second electrode that are sequentially stacked, wherein
the first ferroelectric function layer and the second ferroelectric function layer each comprise a ferroelectric oxide layer, the first ferroelectric function layer and/or the second ferroelectric function layer further comprise/comprises a doping layer, electronegativity of the doping layer is different from electronegativity of the ferroelectric oxide layer, and a doping concentration of the doping layer in the first ferroelectric function layer is different from a doping concentration of the doping layer in the second ferroelectric function layer.

2. The chip according to claim 1, wherein a work function of the first electrode is less than a work function of the second electrode; or
a work function of the first electrode is equal to a work function of the second electrode.

3. The chip according to claim 2, wherein the electronegativity of the doping layer is less than the electronegativity of the ferroelectric oxide layer, and the doping concentration of the doping layer in the first ferroelectric function layer is greater than the doping concentration of the doping layer in the second ferroelectric function layer.

4. The chip according to claim 3, wherein the first ferroelectric function layer and the second ferroelectric function layer each comprise the doping layer; or
the first ferroelectric function layer comprises the doping layer, and the doping concentration of the doping layer in the second ferroelectric function layer is 0.

5. The chip according to claim 3 or 4, wherein a material of the ferroelectric oxide layer comprises HfO₂-ZrO₂, and a material of the doping layer comprises at least one of La₂O₂, Y₂O₂, CeO₂, SrO, and Gd₂O₃.

6. The chip according to claim 2, wherein the electronegativity of the doping layer is greater than the electronegativity of the ferroelectric oxide layer, and the doping concentration of the doping layer in the first ferroelectric function layer is less than the doping concentration of the doping layer in the second ferroelectric function layer.

7. The chip according to claim 6, wherein the first ferroelectric function layer and the second ferroelectric function layer each comprise the doping layer; or
the doping concentration of the doping layer in the first ferroelectric function layer is 0, and the second ferroelectric function layer comprises the doping layer.

8. The chip according to claim 6 or 7, wherein a material of the ferroelectric oxide layer comprises HfO₂-ZrO₂, and the doping layer comprises at least one of Al₂O₃, SiO₂, Ga₂O₃, and GeO₂.

9. The chip according to any one of claims 1 to 4, and 6 and 7, wherein a material of the doping layer comprises a trivalent element.

10. The chip according to any one of claims 1 to 9, wherein a ferroelectric field effect transistor and/or a two-dimensional capacitor structure are/is integrated in the chip;
the first electrode, the ferroelectric function layer, and the second electrode are used as a gate of the ferroelectric field effect transistor; and/or
the first electrode, the ferroelectric function layer, and the second electrode are used as the two-dimensional capacitor structure, the first electrode is a first pole of the two-dimensional capacitor structure, and the second electrode is a second pole of the two-dimensional capacitor structure.

11. The chip according to any one of claims 1 to 9, wherein a ferroelectric random access memory is integrated in the chip, the ferroelectric random access memory comprises a plurality of capacitors and a plurality of plate lines, second poles of the plurality of capacitors are coupled to each other, and first poles of the plurality of capacitors are respectively coupled to different plate lines; and
the chip comprises a plurality of first electrodes and one second electrode, the plurality of first electrodes are used as the plurality of plate lines, and the second electrode is used as the second poles of the plurality of capacitors.

12. A chip, comprising a first electrode, a first ferroelectric function layer, a second ferroelectric function layer, and a second electrode that are sequentially stacked, wherein
the first ferroelectric function layer and the second ferroelectric function layer each comprise a ferroelectric oxide layer, the first ferroelectric function layer further comprises a first doping layer, the second ferroelectric function layer further comprises a second doping layer, electronegativity of the first doping layer is different from electronegativity of the second doping layer, and each of the electronegativity of the first doping layer and the electronegativity of the second doping layer is different from electronegativity of the ferroelectric oxide layer.

13. The chip according to claim 12, wherein a work function of the second electrode is greater than a work function of the first electrode; or
a work function of the second electrode is equal to a work function of the first electrode.

14. The chip according to claim 13, wherein the electronegativity of the first doping layer is less than the electronegativity of the ferroelectric oxide layer, and the electronegativity of the second doping layer is greater than the electronegativity of the ferroelectric oxide layer.

15. The chip according to any one of claims 12 to 14, wherein materials of the first doping layer and the second doping layer comprise a trivalent element.

16. The chip according to claim 14, wherein a material of the ferroelectric oxide layer comprises HfO₂-ZrO₂, a material of the first doping layer comprises at least one of La₂O₃, Y₂O₃, CeO₂, SrO, and Gd₂O₃. and the second doping layer comprises at least one of Al₂O₃, SiO₂, Ga₂O₃, and GeO₂.

17. The chip according to any one of claims 12 to 16, wherein a ferroelectric field effect transistor and/or a two-dimensional capacitor structure are/is integrated in the chip;
the first electrode, the ferroelectric function layer, and the second electrode are used as a gate of the ferroelectric field effect transistor; and/or
the first electrode, the ferroelectric function layer, and the second electrode are used as the two-dimensional capacitor structure, the first electrode is a first pole of the two-dimensional capacitor structure, and the second electrode is a second pole of the two-dimensional capacitor structure.

18. The chip according to any one of claims 12 to 16, wherein a ferroelectric random access memory is integrated in the chip, the ferroelectric random access memory comprises a plurality of capacitors and a plurality of plate lines, second poles of the plurality of capacitors are coupled to each other, and first poles of the plurality of capacitors are respectively coupled to different plate lines; and
the chip comprises a plurality of first electrodes and one second electrode, the plurality of first electrodes are used as the plurality of plate lines, and the second electrode is used as the second poles of the plurality of capacitors.

19. A terminal, comprising a circuit board and the chip according to any one of claims 1 to 11 or any one of claims 12 to 18, wherein the chip is disposed on the circuit board.
